# EUROPEAN PATENT APPLICATION

(11) **EP 4 742 244 A1**
(43) Date of publication of application: **13.05.2026**
(21) Application number: 25197583.5
(22) Date of filing: 22.08.2025
(51) Int. Cl.: G11C 7/10

(54) **STORAGE DEVICE AND METHOD OF OPERATING STORAGE DEVICE**

(30) Priority: 06.11.2024 KR 20240155842
(71) Applicant: SAMSUNG ELECTRONICS CO., LTD., Yeongtong-gu Suwon-si, Gyeonggi-do 16677 (KR)
(72) Inventor: SON, Younghoon, 16677 Suwon-si, Gyeonggi-do (KR); RYU, Jinho, 16677 Suwon-si, Gyeonggi-do (KR); KANG, Kyoungtae, 16677 Suwon-si, Gyeonggi-do (KR); KIM, Sangyun, 16677 Suwon-si, Gyeonggi-do (KR); BYUN, Jindo, 16677 Suwon-si, Gyeonggi-do (KR); CHOI, Youngdon, 16677 Suwon-si, Gyeonggi-do (KR)
(74) Representative: Kuhnen & Wacker Patent- und Rechtsanwaltsbüro PartG mbB

(57) **Abstract**

A storage device includes a memory device and a memory controller to control the memory device by communicating with the memory device through a channel. The memory device includes a plurality of memory chips sharing the channel and each of the plurality of memory chips includes a transmission driver and an adaptive body bias generator. A target memory chip selected by the memory controller, among the plurality of memory chips, includes a first adaptive body bias generator and a first transmission driver. The first adaptive body bias generator applies a first body bias to the first transmission driver in a write mode in which the target memory chip receives a write data from the memory controller and applies a second body bias in a read mode in which the target memory chip transmits a read data to the memory controller.

## Description

### BACKGROUND

A storage device may include a memory device including a plurality of memory chips and a controller to control the memory device. In related memory systems, signal communication between a memory device and a controller may perform at relatively low operating frequencies, as compared with signal communication in memory systems including high speed memory, such as dynamic random-access memory (DRAM) or static random-access memory (SRAM). As demand for high speed storage devices is rising, the integrity (or robustness) of signals communicated between the memory device and the controller and capacitance of input/output pads for reducing channel power become desired in the design and operation of storage device(s) in computing systems and/or mobile communication systems.

### SUMMARY

Some example implementations may provide a storage device capable of reducing capacitance of input/output pads.

Some example implementations may provide a method of operating a storage device, capable of reducing capacitance of input/output pads.

According to some example implementations, a storage device includes a memory device and a memory controller to control the memory device through a channel. The memory device includes a plurality of memory chips sharing the channel and the memory device selects a target memory chip among the plurality of memory chips. The target memory chip includes a first adaptive body bias generator and a first transmission driver. The first adaptive body bias generator applies a first body bias to the first transmission driver based on an operation mode including a write mode or a read mode. In the write mode, the target memory chip receives a write data from the memory controller and in the read mode the target memory chip transmits a read data to the memory controller.

According to some example implementations, a storage includes a memory device and a memory controller to control the memory device through a channel and selects a target memory chip among a plurality of memory chip. The memory device includes the plurality of memory chips sharing a data bus that transfers data and receiving respective chip selection signals from the memory controller. Each of the plurality of memory chips includes a memory cell array, a transmission driver and an adaptive body bias generator, the memory cell array includes a plurality of volatile memory cells coupled to a plurality of word-lines and a plurality of bit-lines and the memory cell array stores the data. The target memory chip includes a first adaptive body bias generator and a first transmission driver. The first adaptive body bias generator applies a first body bias to the first transmission driver based on an operation mode including a write mode or a read mode. In the write mode, the target memory chip receives a write data from the memory controller and in the read mode the target memory chip transmits a read data to the memory controller.

According to some example implementations, there is provided a method of operating a storage device. The storage device includes a memory device and a memory controller to control the memory device by communicating with the memory device through a channel, and the memory device includes a plurality of memory chips sharing the channel. According to the method, that in each of plurality of memory chips is selected as a target memory chip based on a chip address from the memory controller is determined, a first body bias is applied, by a first adaptive body bias generator, to a first transmission driver based on an operation mode being a write mode or a read mode, where the first adaptive body bias generator and the first transmission driver being is included in a first memory chip that is selected as the target memory chip by the memory controller, among the plurality of memory chips, and a second body bias is applied, by a second adaptive body bias generator, to a second transmission driver based on that a corresponding on-die termination function is enabled, where the second adaptive body bias generator and second transmission driver is included in each of one or more non-target memory chips except the first memory chip, among the plurality of memory chips.

Accordingly, in the storage device and the mothed of operating the storage device according to example implementations, an adaptive body bias generator in a selected chip may apply different body bias to a corresponding transmission driver based on an operation mode and an adaptive body bias generator in an unselected chip may apply different body bias to a corresponding transmission driver based on whether an on-die termination (ODT) function is enabled. Therefore, the adaptive body bias generator may apply a reverse body bias to a corresponding transmission driver in the write mode or when the ODT function is disabled and may reduce power consumption by reducing parasitic capacitance.

### BRIEF DESCRIPTION OF THE DRAWINGS

Illustrative, non-limiting example implementations will be more clearly understood from the following detailed description in conjunction with the accompanying drawings.
FIG. 1 is a block diagram illustrating a storage device according to example implementations.
FIG. 2 is a block diagram illustrating an example of the memory controller in the storage device of FIG. 1 according to example implementations.
FIG. 3 illustrates a connection example of the memory controller and the memory device in the storage device of FIG. 1 according to example implementations.
FIG. 4 is a timing diagram illustrating a chip selection operation of the memory device in FIG. 3 according to example implementations.
FIG. 5 is a block diagram illustrating an example of one of the plurality of memory chips in the memory device in FIG. 3 according to example implementations.
FIG. 6A illustrates an example of the data I/O circuit in the memory chip of FIG. 5 according to example implementations.
FIG. 6B is a circuit diagram illustrating a transmission driver in the data I/O circuit in FIG. 6A according to example implementations.
FIG. 7 is a block diagram illustrating an example of the adaptive body bias generator in the memory chip of FIG. 5 according to example implementations.
FIG. 8 is a block diagram illustrating an example of the memory plane in the memory chip of FIG. 5 according to example implementations.
FIG. 9 is a circuit diagram illustrating one of the memory blocks of FIG. 8.
FIG. 10 is a block diagram illustrating a portion of the memory chip of FIG. 5 according to example implementations.
FIG. 11 is a circuit diagram illustrating an example of the transmission driver in the memory chip of FIG. 10 according to example implementations.
FIG. 12 illustrates the storage device of FIG. 3 in the write mode according to example implementations.
FIG. 13 illustrates the storage device of FIG. 3 in the read mode according to example implementations.
FIG. 14 is a table illustrating body bias applied to the transmission drivers in the memory chips in FIGS. 12 and 13.
FIG. 15 is a table illustrating body bias applied to transistors in the transmission driver according to example implementations.
FIGS. 16 and 17 are cross-sectional views of a PMOS transistor and an NMOS transistor in the transmission driver in FIG. 11.
FIG. 18 is a block diagram illustrating an example of the control circuit in the memory chip of FIG. 5 according to example implementations.
FIG. 19 is a block diagram illustrating a storage device according to example implementations.
FIG. 20 is a timing diagram illustrating a chip selection operation of the memory device in FIG. 19 according to example implementations.
FIG. 21 is a timing diagram illustrating an example of ODT control operation of the memory device in FIG. 19 according to example implementations.
FIG. 22 is a block diagram illustrating a storage device according to example implementations.
FIG. 23 is a block diagram illustrating an example of one of the plurality of memory chips in the memory device in FIG. 22 according to example implementations.
FIG. 24 illustrates an example of a first bank array in the memory chip of FIG. 23 according to example implementations.
FIG. 25 is a block diagram illustrating an example of the storage device in FIG. 1 according to example implementations.
FIG. 26 is a flow chart illustrating a method of operating a storage device according to example implementations.
FIG. 27 is a block diagram illustrating an electronic system including a semiconductor device according to some example implementations.

### DETAILED DESCRIPTION

Various example implementations will be described more fully hereinafter with reference to the accompanying drawings, in which some example implementations are shown.

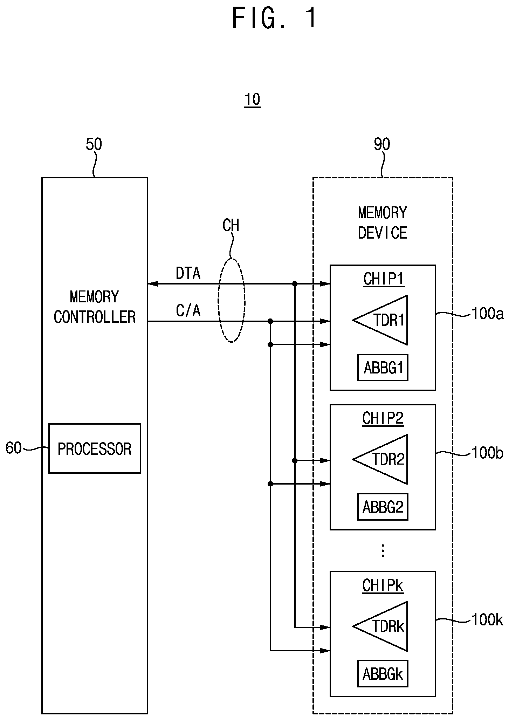

FIG. 1 is a block diagram illustrating a storage device according to example implementations.

Referring to FIG. 1, a storage device 10 may include a memory controller 50 and a memory device 90. The memory device 90 may include a plurality of memory chips (CHIP1, CHIP2, ..., CHIPk) 100a, 100b, ..., 100k and the plurality of memory chips 100a, 100b, ..., 100k may share a channel (e.g., a communication channel) CH. Here, k is an integer greater than two. The memory controller 50 may control the memory device 90 by communicating with the memory device 90 through the channel CH. The memory controller 50 may transmit command/address C/A to the plurality of memory chips 100a, 100b, ..., 100k and may exchange data DTA with the plurality of memory chips 100a, 100b, ..., 100k through the channel CH.

Each of the plurality of memory chips 100a, 100b, ..., 100k may include a respective one of adaptive body bias generators ABBG1, ABBG2, ..., ABBGk and respective one of transmission drivers TDR1, TDR2, ..., TDRk.

The memory controller 50 may select one of plurality of memory chips 100a, 100b, ..., 100k as a target memory chip and may select the rest of the plurality of memory chips 100a, 100b, ..., 100k except the target memory chip as non-target memory chips.

The memory controller 50 may store a data (e.g., a write data) DTA in the target memory chip in a write mode and may read a data (e.g., a read data) DTA from the target memory chip in a read mode.

The body bias generator ABBG1 in the target memory chip (for example, the memory chip 100a) may apply a different body bias to the transmission driver TDR1 in the write mode and in the read mode. For example, the body bias generator ABBG1 may reduce a capacitance of input/output pads in the write mode by applying a reverse body bias to the transmission driver TDR1 in the write mode and by applying a normal body bias to the transmission driver TDR1 in the read mode.

Each of the adaptive body bias generators ABBG2, ..., ABBGk of the non-target memory chips (for example, the memory chips 100b, ..., 100k) may apply a different body bias to a respective one of the transmission drivers TDR2, ..., TDRk based on whether a corresponding on-die termination (ODT) function is enabled. For example, each of the adaptive body bias generators ABBG2, ..., ABBGk may apply a normal body bias to a respective one of the transmission drivers TDR2, ..., TDRk when the ODT function is enabled, may apply a reverse body bias to a respective one of the transmission drivers TDR2, ..., TDRk when the ODT function is disabled and thus may reduce the capacitance of input/output pads.

The memory controller 50 may include a processor 60 and may be referred to as a storage controller.

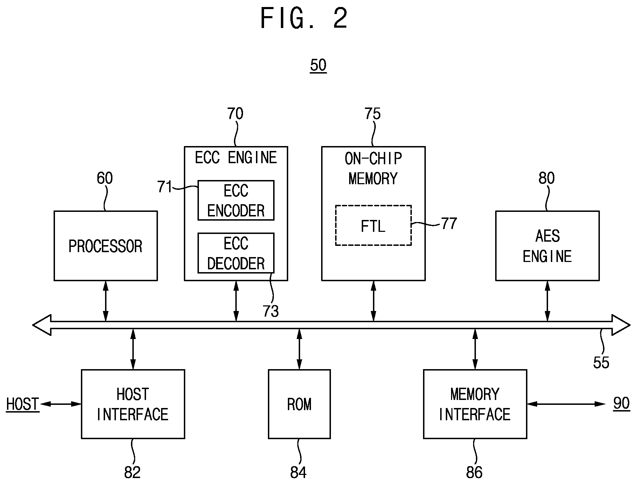

FIG. 2 is a block diagram illustrating an example of the memory controller in the storage device of FIG. 1 according to example implementations.

Referring to FIG. 2, the memory controller 50 may include the processor 60, an error correction code (ECC) engine 70, an on-chip memory 75, an advanced encryption standard (AES) engine 80, a host interface 82, a ROM 84 and a memory interface 86 which are connected via a bus 55.

The processor 60 may control an overall operation of the memory controller 50. The processor 60 may control the ECC engine 70, the on-chip memory 75, the AES engine 80, the host interface 82, the ROM 84 and the memory interface 86. The processor 60 may include one or more cores (e.g., a homogeneous multi-core or a heterogeneous multi-core). The processor 60 may be or include, for example, at least one of a central processing unit (CPU), an image signal processing unit (ISP), a digital signal processing unit (DSP), a graphics processing unit (GPU), a vision processing unit (VPU), and a neural processing unit (NPU). The processor 60 may execute various application programs (e.g., a flash translation layer (FTL) 77 and firmware) loaded onto the on-chip memory 75.

The on-chip memory 75 may store various application programs that are executable by the processor 60. The on-chip memory 75 may operate as a cache memory adjacent to the processor 60. The on-chip memory 80 may store a command, an address, and data to be processed by the processor 60 or may store a processing result of the processor 60. The on-chip memory 75 may be, for example, a storage medium or a working memory including a latch, a register, a static random access memory (SRAM), a dynamic random access memory (DRAM), a thyristor random access memory (TRAM), a tightly coupled memory (TCM), etc.

The processor 60 may execute the FTL 77 loaded onto the on-chip memory 75. The FTL 77 may be loaded onto the on-chip memory 75 as firmware or a program stored in at least one of the plurality of memory chips 100a, 100b, ..., 100k. The FTL 77 may manage mapping between a logical address provided from a host and a physical address of at least one of the plurality of memory chips 100a, 100b, ..., 100k and may include an address mapping table manager managing and updating an address mapping table. The FTL 77 may further perform a garbage collection operation, a wear leveling operation, and the like, as well as the address mapping described above. The FTL 77 may be executed by the processor 60 for addressing one or more of the following aspects of at least one of the plurality of memory chips 100a, 100b, ..., 100k: overwrite- or in-place write-impossible, a life time of a memory cell, a limited number of program-erase (PE) cycles, and an erase speed slower than a write speed.

Memory cells of the plurality of memory chips 100a, 100b, ..., 100k may have the physical characteristic that a threshold voltage distribution varies due to causes, such as a program elapsed time, a temperature, program disturbance, and read disturbance, etc.. For example, data stored at the plurality of memory chips 100a, 100b, ..., 100k becomes erroneous due to the above causes.

The memory controller 50 may utilize a variety of error correction techniques to correct such errors. For example, the memory controller 50 may include the ECC engine 70. The ECC engine 70 may correct errors which occur in the data stored in the plurality of memory chips 100a, 100b, ..., 100k. The ECC engine 70 may include an ECC encoder 71 and an ECC decoder 73. The ECC encoder 71 may perform an ECC encoding operation on data to be stored in the at least one of the plurality of memory chips 100a, 100b, ..., 100k. The ECC decoder 73 may perform an ECC decoding operation on data read from the at least one of the plurality of memory chips 100a, 100b, ..., 100k. The ECC decoder 73 may correct errors in a hard decision data based on the hard decision data and a soft decision data read from at least one of the plurality of memory chips 100a, 100b, ..., 100k.

The ROM 84 may store a variety of information, needed for the memory controller 50 to operate, in firmware.

The AES engine 80 may perform at least one of an encryption operation and a decryption operation on data input to the memory controller 50 by using a symmetric-key algorithm. Although not illustrated in detail, the AES engine 80 may include an encryption module and a decryption module. For example, the encryption module and the decryption module may be implemented as separate modules. For another example, one module capable of performing both encryption and decryption operations may be implemented in the AES engine 80.

The memory controller 50 may communicate with a host through the host interface 82. For example, the host interface 82 may include Universal Serial Bus (USB), Multimedia Card (MMC), embedded-MMC, peripheral component interconnection (PCI), PCI-express, Advanced Technology Attachment (ATA), Serial-ATA, Parallel-ATA, small computer small interface (SCSI), enhanced small disk interface (ESDI), Integrated Drive Electronics (IDE), Mobile Industry Processor Interface (MIPI), Nonvolatile memory express (NVMe), Universal Flash Storage (UFS), and etc. The memory controller 50 may communicate with the memory device 90 through the memory interface 86. The memory interface 86 may be referred to as a storage interface.

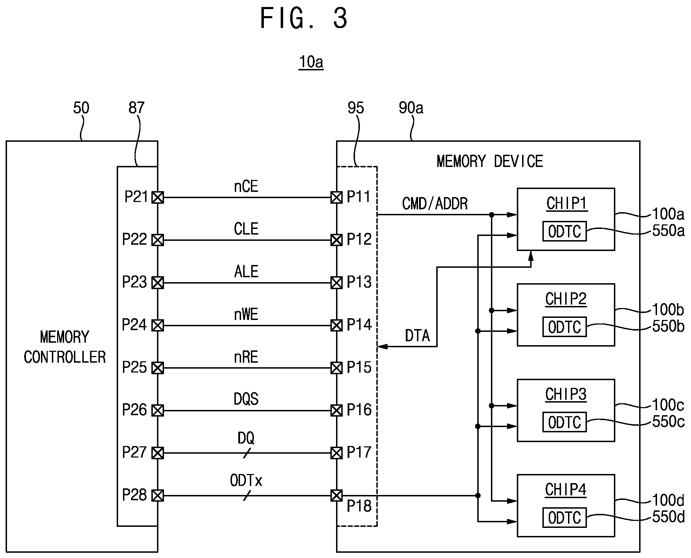

FIG. 3 illustrates a connection example of the memory controller and the memory device in the storage device of FIG. 1 according to example implementations.

Referring to FIG. 3, a storage device 10a may include a memory device 90a and a memory controller 50. FIG. 3 illustrates an interface between the memory device 90a and the memory controller 50 in detail.

The memory device 90a may include first to eighth pins P11, P12, P13, P14, P15, P16, P17 and P18, an interface circuit 95 and a plurality of memory chips (CHIP1, CHIP2, CHIP3 and CHIP4) 100a, 100b, 100c and 100d. The interface circuit 95 may be referred to as a first interface circuit. Each of the plurality of memory chips 100a, 100b, 100c and 100d may include a respective one of ODT circuits ODTC 550a, 550b, 550c and 550d.

The interface circuit 95 may receive a chip enable signal nCE from the memory controller 50 through the first pin P11. The interface circuit 95 may transmit and receive signals to and from the memory controller 50 through the second to eighth pins P12 to P18 in response to the chip enable signal nCE. For example, when the chip enable signal nCE is in an enable state (e.g., a low level), the interface circuit 95 may transmit and receive signals to and from the memory controller 50 through the second to eighth pins P12 to P18.

The interface circuit 95 may receive a command latch enable signal CLE, an address latch enable signal ALE and a write enable signal nWE from the memory controller 50 through the second to fourth pins P12 to P14. The interface circuit 95 may receive a data signal DQ from the memory controller 50 through the seventh pin P17 or may transmit the data signal DQ to the memory controller 50. A command CMD, an address ADDR and data DTA may be transmitted via the data signal DQ. For example, the data signal DQ may be transmitted through a plurality of data signal lines. In this case, the seventh pin P17 may include a plurality of pins respectively corresponding to a plurality of data signals DQ(s).

The interface circuit 95 may obtain the command CMD from the data signal DQ, which is received in an enable section (e.g., a high-level state) of the command latch enable signal CLE based on toggle time points of the write enable signal nWE. The interface circuit 95 may obtain the address ADDR from the data signal DQ, which is received in an enable section (e.g., a high-level state) of the address latch enable signal ALE based on the toggle time points of the write enable signal nWE.

In some example implementations, the write enable signal nWE may be maintained at a static state (e.g., a high level or a low level) and may toggle between the high level and the low level. For example, the write enable signal nWE may toggle in a section in which the command CMD or the address ADDR is transmitted. Thus, the interface circuit 95 may obtain the command CMD or the address ADDR based on the toggle time points of the write enable signal nWE.

The interface circuit 95 may receive a read enable signal nRE from the memory controller 50 through the fifth pin P15. The interface circuit 95 may receive a data strobe signal DQS from the memory controller 50 through the sixth pin P16 or may transmit the data strobe signal DQS to the memory controller 50.

In a data output operation of the memory device 90a, the interface circuit 95 may receive the read enable signal nRE, which toggles through the fifth pin P15, before outputting the data DTA. The interface circuit 95 may generate the data strobe signal DQS, which toggles based on the toggling of the read enable signal nRE. For example, the interface circuit 95 may generate the data strobe signal DQS, which starts toggling after a predetermined delay (e.g., tDQSRE), based on a toggling start time of the read enable signal nRE. The interface circuit 105 may transmit the data signal DQ including the data DTA based on a toggle time point of the data strobe signal DQS. Thus, the data DTA may be aligned with the toggle time point of the data strobe signal DQS and may be transmitted to the memory controller 50.

In a data input operation of the memory device 90a, when the data signal DQ including the data DTA is received from the memory controller 50, the interface circuit 95 may receive the data strobe signal DQS, which toggles, along with the data DTA from the memory controller 50. The interface circuit 95 may obtain the data DTA from the data signal DQ based on toggle time points of the data strobe signal DQS. For example, the interface circuit 95 may sample the data signal DQ at rising and falling edges of the data strobe signal DQS and may obtain the data DTA.

The interface circuit 95 may receive an ODT signal ODTx from the memory controller 50 through the eighth pin P18. The ODT signal ODTx may indicate (e.g., designate) whether each of the ODT circuits 550a, 550b, 550c and 550d is enabled.

The interface circuit 95 may commonly provide the command/address CMD/ADDR to the plurality of memory chips 100a, 100b, 100c and 100d, may provide the data DTA to a target memory chip (for example, the memory chip 100a) among the plurality of memory chips 100a, 100b, 100c and 100d and may transmit the data DTA received from the target memory chip to the memory controller 50. Hereinafter, it is assumed that the memory chip 100a is selected as the target memory chip by the memory controller 50.

The memory controller 50 may include first to eighth pins P21, P22, P23, P24, P25, P26, P27 and P28 and an interface circuit 87. The interface circuit 87 may be referred to as a second interface circuit. The interface circuit 87 may correspond to the memory interface 86 in FIG. 2. The first to eighth pins P21 to P28 may correspond to the first to eighth pins P11 to P18 of the memory device 90a, respectively.

The interface circuit 87 may transmit the chip enable signal nCE to the memory device 90a through the first pin P21. The interface circuit 87 may transmit and receive signals to and from the memory device 90a, which is selected by the chip enable signal nCE, through the second to eighth pins P22 to P28.

The interface circuit 87 may transmit the command latch enable signal CLE, the address latch enable signal ALE and the write enable signal nWE to the memory device 90a through the second to fourth pins P22 to P24. The interface circuit 87 may transmit or receive the data signal DQ to and from the memory device 90a through the seventh pin P27.

The interface circuit 87 may transmit the data signal DQ including the command CMD or the address ADDR to the memory device 90a along with the write enable signal nWE, which toggles. The interface circuit 87 may transmit the data signal DQ including the command CMD to the memory device 90a by transmitting the command latch enable signal CLE having an enable state. Also, the interface circuit 87 may transmit the data signal DQ including the address ADDR to the memory device 90a by transmitting the address latch enable signal ALE having an enable state.

The interface circuit 87 may transmit the read enable signal nRE to the memory device 90a through the fifth pin P25. The interface circuit 87 may receive or transmit the data strobe signal DQS from or to the memory device 90a through the sixth pin P26.

The interface circuit 87 may designate whether each of the ODT circuit 550a, 550b, 550c and 550d is enabled by transmitting the ODT signal ODTx to the plurality of memory chips 100a, 100b, 100c and 100d through the eighth pin P28.

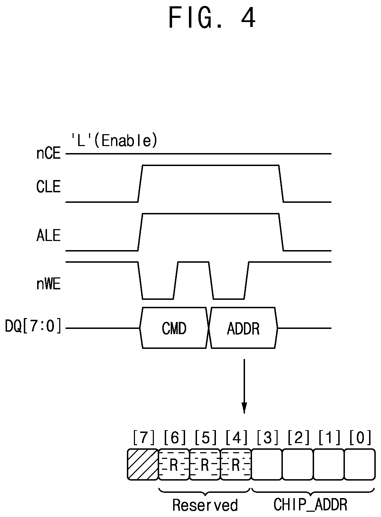

FIG. 4 is a timing diagram illustrating a chip selection operation of the memory device in FIG. 3 according to example implementations.

Referring to FIGS. 3 and 4, a chip selection operation may be an operation to select a target memory chip among a plurality of memory chips based on a chip enable signal nCE and the data signal DQ and may be performed through a chip enable reduction (CER) mode. During an interval in which the chip enable signal nCE is in an enable state (e.g., a low level) and each of the command latch enable signal CLE and the address latch enable signal ALE is in an enable state (e.g., a high level), the memory device 90a may receive the command CMD and the address ADDR through the data signal DQ received through the plurality of pins P17. For example, the command CMD may be 'E1h' and the command CMD and the address ADDR may be transmitted as a command set.

For example, a portion of bits of the address ADDR may include a chip address CHIP_ADDR, and the memory device 90a may determine a target memory chip and non-target memory chips among the plurality of memory chips 100a, 100b, 100c and 100d based on the chip address CHIP _ADDR. Each of the plurality of memory chips 100a, 100b, 100c and 100d may receive the chip address CHIP_ADDR, may compare the chip address CHIP_ADDR with an identifier address identifying respective one of the plurality of memory chips 100a, 100b, 100c and 100d and may determine whether each of the plurality of memory chips 100a, 100b, 100c and 100d is the target memory chip or the non-target memory chip based on a result of the comparison.

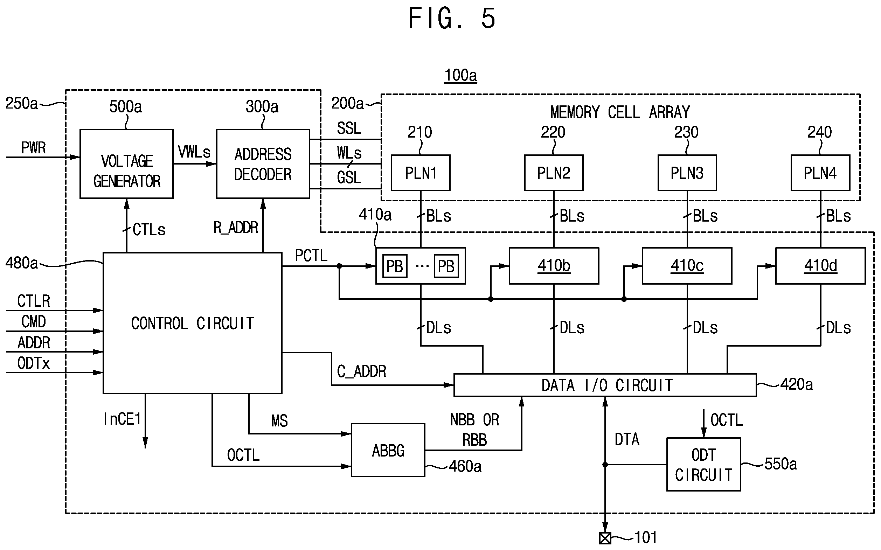

FIG. 5 is a block diagram illustrating an example of one of the plurality of memory chips in the memory device in FIG. 3 according to example implementations.

In FIG. 5, a configuration of the memory chip 100a is illustrated and each configuration of the memory chips 100b, 100c and 100d may be substantially the same as the configuration of the memory chip 100a.

Referring to FIG. 5, the memory chip 100a may include a memory cell array 200a and a peripheral circuit 250a.

The memory cell array 200a may include memory planes PLN1 (210), PLN2 (220), PLN3 (230) and PLN4 (240) corresponding to different bit-lines.

The peripheral circuit 250a may include a plurality of page buffer circuits 410a, 410b, 410c and 410d, a data input/output (I/O) circuit 420a, an adaptive body bias generator 460a, a control circuit 480a, a voltage generator 500a, an ODT circuit 550a, and an address decoder 300a.

The memory cell array 200a may be coupled to the address decoder 300a through a string selection line SSL, a plurality of word-lines WLs, and a ground selection line GSL. Each of the plurality of page buffer circuits 410a, 410b, 410c and 410d may be connected to a respective one of the plurality of memory planes 210, 220, 230 and 240 through corresponding bit-lines BLs. The plurality of memory planes 210, 220, 230 and 240 may include a plurality of nonvolatile memory cells coupled to the plurality of word-lines WLs and the plurality of bit-lines BLs.

Each of the plurality of memory planes 210, 220, 230 and 240 may include a plurality of memory blocks, and each of the memory blocks may have a three-dimensional (3D) structure. Each of the memory blocks may include a plurality of (vertical) cell strings and each of the cell strings includes a plurality of memory cells stacked with respect to each other.

Each of the plurality of page buffer circuits 410a, 410b, 410c and 410d may be connected to the data I/O circuit 420a through corresponding data lines DLs.

The control circuit 480a may receive a command CMD, an address ADDR, a control signal CTRL and an ODT signal ODTx from the memory controller 50 and may control an erase loop, a program loop and a read operation of the memory device 100a based on the command CMD, the address ADDR, and the control signal CTRL. The program loop may include a program operation and a program verification operation and the erase loop may include an erase operation and an erase verification operation. The control circuit 480a may determine whether to enable the ODT circuit 550a based on the ODT signal ODTx. In addition, the control circuit 480a may control the adaptive body bias generator 460a based on the command CMD and the ODT signal ODTx.

In example implementations, the control circuit 480a may generate control signals CTLs, which are used for controlling the voltage generator 500a, based on the command CMD, may provide the control signals CTLs to the voltage generator 500a, may generate a page buffer control signal PCTL for controlling the plurality of page buffer circuits 410a, 410b, 410c and 410d, and may provide the page buffer control signal PCTL to the plurality of page buffer circuits 410a, 410b, 410c and 410d.

In addition, the control circuit 480a may generate a mode signal MS designating a write mode or a read mode based on the command CMD and may provide the mode signal MS to the adaptive body bias generator 460a. The control circuit 480a may generate an ODT control signal OCTL based on the ODT signal ODTx and may provide the ODT control signal OCTL to the adaptive body bias generator 460a and the ODT circuit 550a. In addition, the control circuit 480a may selectively activate an internal chip enable signal InCE1 bay comparing the chip address included in the address (signal) ADDR with the identifier address and may indicate that the memory chip 100a is the target memory chip.

In addition, the control circuit 480a may generate a row address R_ADDR and a column address C_ADDR based on the address (signal) ADDR. The control circuit 480a may provide the row address R_ADDR to the address decoder 300a and may provide the column address C_ADDR to the data I/O circuit 420a.

The address decoder 300a may be coupled to the memory cell array 200a through the string selection line SSL, the plurality of word-lines WLs, and the ground selection line GSL. During program operation or read operation, the address decoder 300a may determine one of the plurality of word-lines WLs as a selected word-line based on the row address R_ADDR and may determine rest of the plurality of word-lines WLs except the selected word-line as unselected word-lines.

The voltage generator 500a may generate word-line voltages VWLs associated with operations of the memory chip 100a using a power PWR provided from the memory controller 50 based on control signals CTLs from the control circuit 480a. The word-line voltages VWLs may include a program voltage, a read voltage, a pass voltage, an erase verification voltage, or a program verification voltage. The word-line voltages VWLs may be applied to the plurality of word-lines WLs through the address decoder 300a.

For example, during the erase operation, the voltage generator 500a may apply an erase voltage to a channel of cell strings of a selected memory block and may apply a ground voltage to all word-lines of the selected memory block. During the erase verification operation, the voltage generator 500a may apply an erase verification voltage to all word-lines of the selected memory block or may apply the erase verification voltage to the word-lines of the selected memory block by word-line basis.

For example, during the program operation, the voltage generator 500a may apply a program voltage to the selected word-line and may apply a program pass voltage to the unselected word-lines. In addition, during the program verification operation, the voltage generator 500a may apply a program verification voltage to the selected word-line and may apply a verification pass voltage to the unselected word-lines. In addition, during the read operation, the voltage generator 500a may apply a read voltage to the selected word-line and may apply a read pass voltage to the unselected word-lines.

Each of the plurality of page buffer circuits 410a, 410b, 410c and 410d may include a plurality of page buffers PB. Each of the plurality of page buffer circuits 410a, 410b, 410c and 410d may temporarily store data to be programmed in a selected page or data read out from the selected page of the memory cell array 200a.

In example implementations, page buffer units included in each of the plurality of page buffers PB and cache latches included in each of the plurality of page buffers PB may be apart from each other, and have separate structures. Accordingly, the degree of freedom of wirings on the page buffer units may be improved, and the complexity of a layout may be reduced. In addition, because the cache latches are adjacent to data I/O lines, the distance between the cache latches and the data I/O lines may be reduced, and thus, data I/O speed may be improved.

The data I/O circuit 420 may be connected to a data I/O pin 101, may receive the data DTA from the memory controller 50 or may transmit the data DTA to the memory controller 50.

The adaptive body bias generator 460a may apply different body bias to a transmission driver in the data I/O circuit 420a in a write mode and a read mode based on the mode signal MS. For example, in the write mode in which the memory chip 100a receives the data DTA from the memory controller 50, the adaptive body bias generator 460a may apply a reverse body bias RBB to the transmission driver in the data I/O circuit 420a and in the read mode in which the memory chip 100a transmits the data DTA to the memory controller 50, the adaptive body bias generator 460a may apply a normal body bias NBB to the transmission driver in the data I/O circuit 420a.

The ODT circuit 550a may be coupled to the data I/O pin 101, may be selectively enabled based on the ODT control signal OCTL and may provide a termination resistance to a data transmission line coupled to the data I/O pin 101 when the data I/O circuit 420a transmits the data DTA or receives the data DTA.

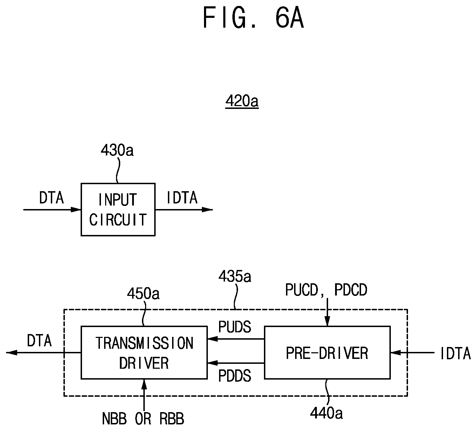

FIG. 6A illustrates an example of the data I/O circuit in the memory chip of FIG. 5 according to example implementations.

Referring to FIG. 6A, the data I/O circuit 420a may include a data input circuit 430a and a data output circuit 435a. The data output circuit 435a may include a pre-driver 440a and an transmission driver 450a.

The data input circuit 430a may receive the data DTA based on the data signal DQ from the memory controller 30a, may convert the data DTA into an internal data IDTA, and may provide the internal data IDTA to one of the page buffer circuits 410a, 410b, 410d and 410d. The data output circuit 435a may convert the internal data IDTA from one of the page buffer circuits 410a, 410b, 410d and 410d and may provide the data DTA to the memory controller 50 through the interface circuit 95.

The pre-driver 440a may receive the internal data IDTA, may generate a pull-up driving signal PUDS and a pull-down driving signal PDDS based on a pull-up control code PUCD and a pull-down control code PDCD, and may provide the pull-up driving signal PUDS and the pull-down driving signal PDDS to the transmission driver 450a.

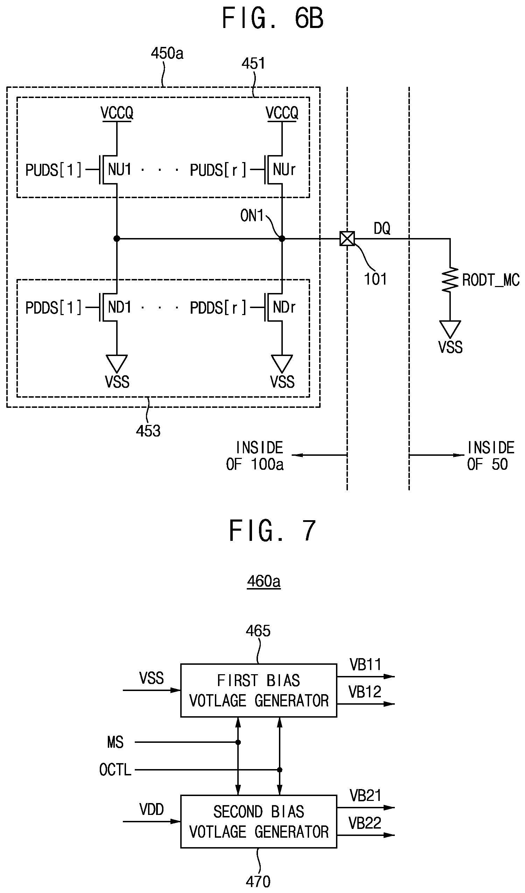

For example, when the internal data IDTA is at a high level, the pre-driver 440a may buffer the pull-up control code PUCD and generate the pull-up driving signal PUDS to be substantially the same as the pull-up control code PUCD, and may generate the pull-down driving signal PDDS for turning off all transistors included in a pull-down driver (such as a pull-down driver 453 shown in FIG. 6B) of the transmission driver 450a. Contrarily, when the internal data IDTA is at a low level, the pre-driver 440a may buffer the pull-down control code PDCD and generate the pull-down driving signal PDDS to be substantially the same as the pull-down control code PDCD, and generate the pull-up driving signal PUDS for turning off all transistors included in a pull-up driver (such as a pull-up driver 451 shown in FIG. 6B) of the transmission driver 450a. The pre-driver 440a may determine a current generated by the pull-up driver 451 and a resistance of the pull-down driver 453 (shown in FIG. 6B) when the transmission driver 450a outputs the data DTA.

The transmission driver 450a may receive the normal body bias NBB or the reverse body bias RBB based on an operation mode.

FIG. 6B is a circuit diagram illustrating a transmission driver in the data I/O circuit in FIG. 6A according to example implementations.

Referring to FIG. 6B, the transmission driver 450a may include the pull-up driver 451 and the pull-down driver 453.

The pull-up driver 451 may include first through r-th (r is a natural number greater than one) pull-up transistors NU1 through NUr connected between a power supply voltage VCCQ and an output node ON1. Each of the first through r-th pull-up transistors NU1 through NUr may be an n-type metal oxide semiconductor (NMOS) transistor.

The pull-down driver 453 may include first through r-th pull-down transistors ND1 through NDr connected between the output node ON1 and a ground voltage VSS. Each of the first through r-th pull-down transistors ND1 through NDr may be an NMOS transistor.

When the internal data IDTA is at the high level, the pull-up driver 451 may receive the pull-up driving signal PUDS (e.g., PUDS[1] through PUDS[r]) corresponding to the pull-up control code PUCD from the pre-driver 440a and generate the current determined by the pull-up control code PUCD. The pull-down transistors ND1 through NDr included in the pull-down driver 453 may all be turned off according to the pull-down driving signal PDDS (e.g., PDDS[1] through PDDS[r]).

At this time, the current generated by the pull-up driver 451 may be transmitted to an on-die termination (ODT) resistor RODT_MC in the memory controller 50 via the data I/O pin 101. The data signal DQ that the ODT resistor RODT_MC receives is determined by the current generated by the pull-up driver 451 and the ODT resistor RODT_MC.

When the internal data IDTA is at the low level, the pull-up transistors NU1 through NUr included in the pull-up driver 451 may all be turned off according to the pull-up driving signal PUDS. The pull-down driver 453 may receive the pull-down driving signal PDDS corresponding to the pull-down control code PDCD from the pre-driver 440a and may have a resistance determined by the pull-down control code PDCD.

At this time, no current is generated by the pull-up driver 451, and therefore, the data signal DQ that the ODT resistor RODT_MC receives has an output low level voltage which is substantially the same as the ground voltage VSS.

According to example implementations, the total resistance, e.g., a termination resistance (RTT), of the pull-up driver 451 or the pull-down driver 453 may be changed in response to a particular pull-up or pull-down driving signal PUDS or PDDS.

FIG. 7 is a block diagram illustrating an example of the adaptive body bias generator in the memory chip of FIG. 5 according to example implementations.

Referring to FIG. 7, the adaptive body bias generator 460a may include a first bias voltage generator 465 and a second bias voltage generator 470.

When the memory chip 100a including the adaptive body bias generator 460a is selected as the target memory chip, the first bias voltage generator 465 may generate bias voltages VB11 and VB12 based on the mode signal MS and the ground voltage VSS and may apply the bias voltages VB11 and VB12 to bodies of NMOS transistors in the transmission driver TDR1 in FIG. 1. The second bias voltage generator 470 may generate bias voltages VB21 and VB22 based on the mode signal MS and a power supply voltage VDD and may apply the bias voltages VB21 and VB22 to bodies of PMOS transistors in the transmission driver TDR1 in FIG. 1.

The bias voltage VB11 may correspond to the ground voltage VSS and the bias voltage VB12 may correspond to a negative voltage smaller than the ground voltage VSS. The bias voltage VB21 may correspond to the power supply voltage VDD and the bias voltage VB22 may correspond to a voltage greater than the power supply voltage VDD.

When the memory chip 100a including the adaptive body bias generator 460a is a non-target memory chip, the first bias voltage generator 465 may generate the bias voltages VB11 and VB12 based on the ODT control signal OCTL and the ground voltage VSS and may apply the bias voltages VB11 and VB12 to bodies of NMOS transistors in the transmission driver TDR1 in FIG. 1. The second bias voltage generator 470 may generate the bias voltages VB21 and VB22 based on the ODT control signal OCTL and the power supply voltage VDD and may apply the bias voltages VB21 and VB22 to bodies of PMOS transistors in the transmission driver TDR1 in FIG. 1.

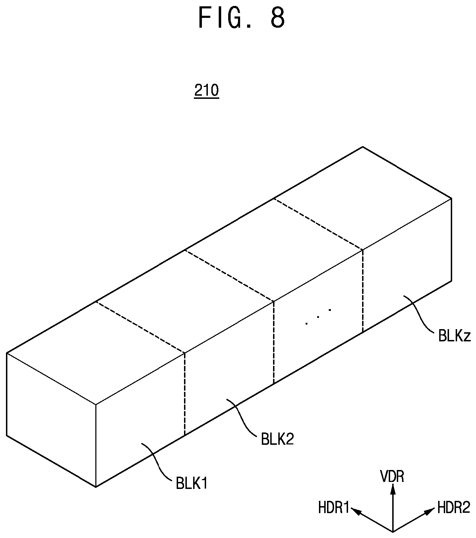

FIG. 8 is a block diagram illustrating an example of the memory plane in the memory chip of FIG. 5 according to example implementations.

Referring to FIG. 8, the memory plane 210 may include a plurality of memory blocks BLK1, BLK2, ..., BLKz which extend along a plurality of directions HDR1, HDR2 and VDR. Here, z is an integer greater than two. In some implementations, the memory blocks BLK1, BLK2, ..., BLKz are selected by the address decoder 300a in FIG. 5. For example, the address decoder 300a may select a memory block corresponding to a block address among the memory blocks BLK1, BLK2, ..., BLKz.

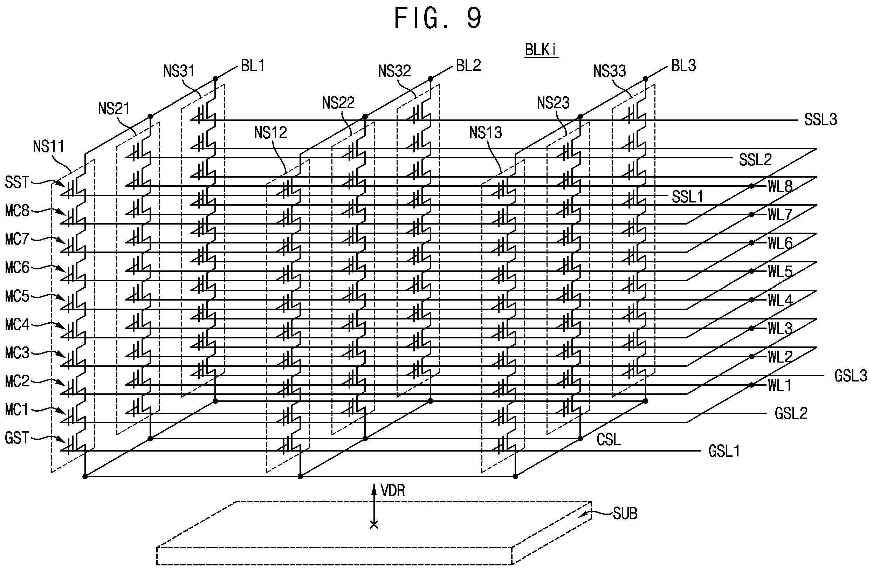

FIG. 9 is a circuit diagram illustrating one of the memory blocks of FIG. 8.

A memory block BLKi of FIG. 9 may be formed on a substrate SUB in a three-dimensional structure (or a vertical structure). For example, a plurality of (memory) cell strings included in the memory block BLKi may be formed in the vertical direction VDR perpendicular to the substrate SUB.

Referring to FIG. 9, the memory block BLKi may include a plurality of cell strings NS11, NS21, NS31, NS12, NS22, NS32, NS13, NS23 and NS33 (hereinafter, represented as NS11 to NS33) coupled between bit-lines BL1, BL2 and BL3 and a common source line CSL. Each of the cell strings NS11 to NS33 may include a string selection transistor SST, a plurality of memory cells MC1, MC2, MC3, MC4, MC5, MC6, MC7 and MC8 (hereinafter represented as MC1 to MC8), and a ground selection transistor GST. In FIG. 9, each of the cell strings NS11 to NS33 is illustrated to include eight memory cells MC1 to MC8. However, present disclosure are not limited thereto. In some example implementations, each of the cell strings NS11 to NS33 may include any number of memory cells.

The string selection transistor SST may be connected to corresponding string selection lines SSL1, SSL2 and SSL3 (hereinafter, represented as SSL1 to SSL3). The plurality of memory cells MC1 to MC8 may be connected to corresponding word-lines WL1 to WL8, respectively. The ground selection transistor GST may be connected to corresponding ground selection lines GSL1, GSL2 and GSL3 (hereinafter, represented as GSL1 to GSL3). The string selection transistor SST may be connected to corresponding bit-lines BL1, BL2 and BL3, and the ground selection transistor GST may be connected to the common source line CSL.

Word-lines (e.g., WL1) having the same height may be commonly connected, and the ground selection lines GSL1 to GSL3 and the string selection lines SSL1 to SSL3 may be separated.

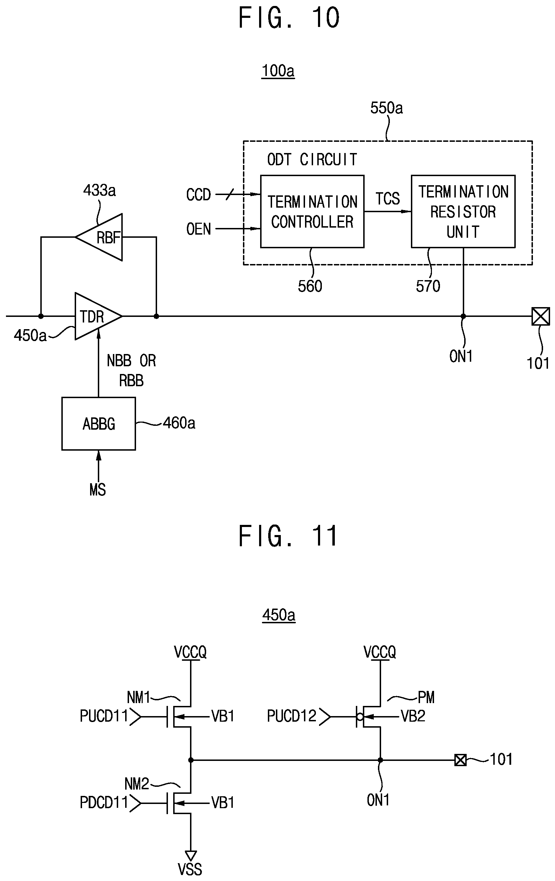

FIG. 10 is a block diagram illustrating a portion of the memory chip of FIG. 5 according to example implementations.

In FIG. 10, the adaptive body bias generator 460a, a reception buffer RBF 433a, the transmission driver 450a and the ODT circuit 550a in the memory chip 100a are illustrated.

Referring to FIG. 10, the reception buffer 433a, the transmission driver 450a and the ODT circuit 550a may be coupled to the data I/O pin 101 at the output node ON1. The transmission driver 450a may drive the data I/O pin 101 based on read data and the reception buffer 433a may receive write data provided through the data I/O pin 101.

The ODT circuit 550a may include a termination controller 560 and a termination resistor unit 570.

The termination resistor unit 570 may be coupled to the data I/O pin 101 and may provide termination impedance to a transmission line coupled to the data I/O pin 101.

The method of controlling ODT according to example implementations may be applied to control terminations of I/O pins for bidirectional communication between the memory controller 50 and the memory chip. Thus the method according to example implementations may be applied to a data strobe pin, a data mask pin, or a termination data strobe pin in addition to the data I/O pin 101. The term "pin" broadly refers to an electrical interconnection for an integrated circuit, e.g., a pad or other electrical contact on the integrated circuit.

In some implementations, the termination resistor unit 570 may perform a pull-up termination operation to provide termination resistance between a power supply voltage node and the data I/O pin 101 and/or a pull-down termination operation to provide termination resistance between a ground node and the data I/O pin 101.

Even though FIG. 10 illustrates some example implementations where a distinct termination resistor unit 570 is equipped, a signal driver itself in the transmission driver 450a may function as a termination resistor. For example, in the write operation, the transmission driver 450a does not transmit read data and the transmission driver 450a functions as the termination resistor unit 570 while the reception buffer 433a is enabled to receive write data.

When the termination resistor unit 570 performs the pull-up termination operation, a voltage of the transmission line connected to the data I/O pin 101 may be maintained substantially at a level of the power supply voltage. As a result, a current flows through the termination resistor unit 570 and the transmission line only when data of a logic low level are transferred.

The termination controller 560 may receive a control code CCD and an output enable signal OEN. The termination controller 560 may generate a termination control signal TCS for controlling the termination resistor unit 570 to adjust the termination impedance based on the control code CCD and the output enable signal OEN. The control code CCD and the output enable signal OEN may be included in the ODT control signal OCTL in FIG. 5.

In some implementations, the output enable signal OEN is activated during a read operation. While the output enable signal OEN is active, the termination controller 560 may provide the termination control signal TCS at a predetermined logic level to control the termination resistor unit 570 not to provide the termination impedance. In that case, the termination resistor unit 570 may be electrically decoupled from the data I/O pin 101 in response to the termination control signal TCS having the predetermined logic level. When the termination resistor unit 570 is electrically decoupled from the data I/O pin 101, the ODT circuit 550a or the termination resistor unit 570 may be referred to as "being disabled".

While the output enable signal OEN is deactivated during a write operation, the termination controller 560 may generate the termination control signal TCS to control the termination resistor unit 570 to provide the termination impedance.

The adaptive body bias generator 460a, based on the mode signal MS indicating the write mode or the read mode, may apply the reverse body bias RBB to the transmission driver 450a in the write mode and apply the normal body bias NBB to the transmission driver 450a in the read mode.

FIG. 11 is a circuit diagram illustrating an example of the transmission driver in the memory chip of FIG. 10 according to example implementations.

Referring to FIG. 11, the transmission driver 450a may include a first NMOS transistor NM1, a second NMOS transistor NM2 and a PMOS transistor PM.

The first NMOS transistor NM1 may be coupled between the power supply voltage VDDQ and the data I/O pin 101, the second NMOS transistor NM2 may be coupled between the data I/O pin 101 and the ground voltage VSS and the PMOS transistor PM may be coupled between the power supply voltage VDDQ and the data I/O pin 101.

The first NMOS transistor NM1 and the PMOS transistor PM may constitute a pull-up driver and the second NMOS transistor NM2 may constitute a pull-down driver. A pull-up control code PUCD11 may be applied to a gate of the first NMOS transistor NM1, a pull-up control code PUCD12 may be applied to a gate of the PMOS transistor PM and a pull-down control code PDCD11 may be applied to a gate of the second NMOS transistor NM2.

The adaptive body bias generator 460a in FIG. 10 may apply a bias voltage VB1 to a body of each of the first NMOS transistor NM1 and the second NMOS transistor NM2 and may apply a bias voltage VB2 to a body of the PMOS transistor PM. The bias voltages VB 1 and VB2 may be applied as a normal body bias or a reverse body bias based on the operation mode of the memory chip 100a.

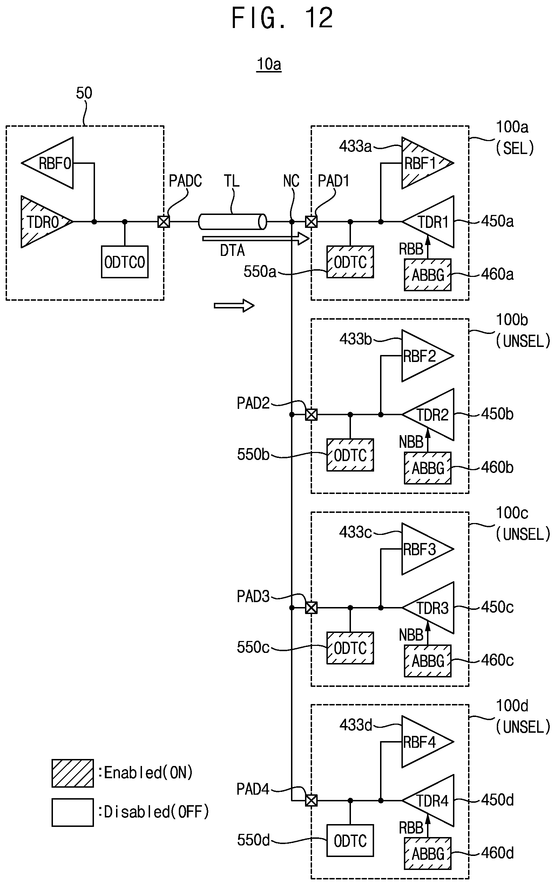

FIG. 12 illustrates the storage device of FIG. 3 in the write mode according to example implementations.

In FIG. 12, assuming that the memory chip 100a is selected as the target memory chip by the memory controller 50 among the plurality of memory chips 100a, 100b, 100c and 100d, and the memory chips 100b, 100c and 100d are unselected as non-target memory chips for convenience of explanation. In addition, assuming that the ODT circuits 550b and 550c in the memory chips 100b and 100c are enabled and the ODT circuit 550d in the memory chip 100d is disabled. In FIG. 12, the enabled elements are hatched.

Referring to FIG. 12, the memory controller 50 may be connected to the memory chips 100a, 100b, 100c and 100d through data I/O pins PADC, PAD1, PAD2, PAD3 and PAD4 and a transmission line TL. The transmission line TL may be branched to the data I/O pins PAD1, PAD2, PAD3 and PAD4 of the memory chips 100a, 100b, 100c and 100d at a common node NC.

During the write mode (write operation) in which the data DTA is transmitted to the target memory chip 100 from the memory controller 50, a transmission driver TDR0 is enabled and a reception buffer RBF0 and an ODT circuit ODTC0 are disabled in the memory controller 50. The reception buffer 433a, the ODT circuit 550a and the adaptive body bias generator 460a are enabled and the transmission driver 450a is disabled in the memory chip 100a corresponding to the target memory chip. In addition, reception buffers 433b, 433c and 433d and the transmission drivers 450b, 450c and 450d are disabled in the memory chips 100b, 100c and 100d corresponding to non-target memory chips, the ODT circuits 550b and 550c in the memory chips 100b and 100c are enabled and the ODT circuit 550d in the memory chip 100d is disabled.

The adaptive body bias generator 460a in the memory chip 100a corresponding to the target memory chip applies the reverse body bias RBB to the transmission driver 450a, the adaptive body bias generator 460b in the memory chip 100b including the enabled ODT circuit 550b applies the normal body bias NBB to the transmission driver 450b, the adaptive body bias generator 460c in the memory chip 100c including the enabled ODT circuit 550c applies the normal body bias NBB to the transmission driver 450c, and the adaptive body bias generator 460d in the memory chip 100d including the disabled ODT circuit 550d applies the reverse body bias RBB to the transmission driver 450d.

Therefore, a junction capacitance of each of the transmission drivers 450a and 450d to which the reverse body bias RBB is applied is reduced and thus, a capacitance of the I/O pins PAD1 and PAD4 may be reduced.

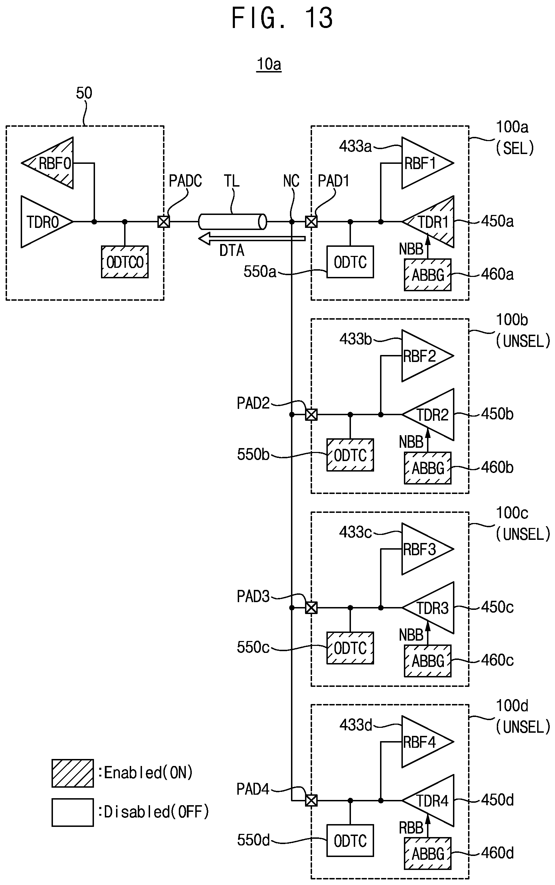

FIG. 13 illustrates the storage device of FIG. 3 in the read mode according to example implementations.

In FIG. 13, assuming that the memory chip 100a is selected as the target memory chip by the memory controller 50 among the plurality of memory chips 100a, 100b, 100c and 100d, and the memory chips 100b, 100c and 100d are unselected as non-target memory chips for convenience of explanation. In addition, assuming that the ODT circuits 550b and 550c in the memory chips 100b and 100c are enabled and the ODT circuit 550d in the memory chip 100d is disabled. In FIG. 13, the enabled elements are hatched.

Referring to FIG. 13, the memory controller 50 may be connected to the memory chips 100a, 100b, 100c and 100d through data I/O pins PADC, PAD 1, PAD2, PAD3 and PAD4 and a transmission line TL. The transmission line TL may be branched to the data I/O pins PAD1, PAD2, PAD3 and PAD4 of the memory chips 100a, 100b, 100c and 100d at a common node NC.

During the read mode (read operation) in which the data DTA is transmitted to the memory controller 50 from the memory chip 100a, a transmission driver TDR0 is disabled and the reception buffer RBF0 and the ODT circuit ODTC0 are enabled in the memory controller 50. The transmission driver 450a and the adaptive body bias generator 460a are enabled and the reception buffer 433a and the ODT circuit 550a are disabled in the memory chip 100a corresponding to the target memory chip. In addition, reception buffers 433b, 433c and 433d and the transmission drivers 450b, 450c and 450d are disabled in the memory chips 100b, 100c and 100d corresponding to non-target memory chips, the ODT circuits 550b and 550c in the memory chips 100b and 100c are enabled and the ODT circuit 550d in the memory chip 100d is disabled.

The adaptive body bias generator 460a in the memory chip 100a corresponding to the target memory chip applies the normal body bias NBB to the transmission driver 450a, the adaptive body bias generator 460b in the memory chip 100b including the enabled ODT circuit 550b applies the normal body bias NBB to the transmission driver 450b, the adaptive body bias generator 460c in the memory chip 100c including the enabled ODT circuit 550c applies the normal body bias NBB to the transmission driver 450c, and the adaptive body bias generator 460d in the memory chip 100d including the disabled ODT circuit 550d applies the reverse body bias RBB to the transmission driver 450d.

Therefore, a junction capacitance of each of the transmission driver 460d to which the reverse body bias RBB is applied is reduced and thus, a capacitance of the I/O pin PAD4 may be reduced.

In FIGS. 12 and 13, the adaptive body bias generator 460a in the memory chip 100a corresponding to the target memory chip may be a first adaptive body bias generator, the transmission driver 450a may be a first transmission driver and a body bias applied by the adaptive body bias generator 460a may be a first body bias. In addition, the adaptive body bias generator 460b in the memory chip 100b including the enabled ODT circuit 550b may be a second adaptive body bias generator, the transmission driver 450b may be a second transmission driver and a body bias applied by the adaptive body bias generator 460b may be a second body bias. In addition, the adaptive body bias generator 460c in the memory chip 100c including the disabled ODT circuit 550c may be a third adaptive body bias generator, the transmission driver 450c may be a third transmission driver and a body bias applied by the adaptive body bias generator 460c may be a third body bias. In addition, the adaptive body bias generator 460d in the memory chip 100d including the disabled ODT circuit 550d may be a fourth adaptive body bias generator, the transmission driver 450d may be a fourth transmission driver and a body bias applied by the adaptive body bias generator 460d may be a fourth body bias.

In FIGS. 12 and 13, it is illustrated that each of the ODT circuits 550a, 550b, 550c and 550d is separated from respective ones of the transmission drivers 450a, 450b, 450c and 450d in the memory chips 100a, 100b, 100c and 100d. However, according to example implementations, each of the transmission drivers 450a, 450b, 450c and 450d may include an ODT function and the ODT function of each of the transmission drivers 450a, 450b, 450c and 450d may be selectively enabled. That is, each of the adaptive body bias generators 460a, 460b, 460c and 460d may apply the normal body bias NBB or the reverse body bias RBB to a respective one of the transmission drivers 450a, 450b, 450c and 450d based on whether each ODT function of the transmission drivers 450a, 450b, 450c and 450d is enabled. Each of the adaptive body bias generators 460b and 460c may apply the normal body bias NBB to a respective one of the transmission drivers 450b and 450c based on each ODT function of the transmission drivers 450b and 450c being enabled and the adaptive body bias generator 460d may apply the reverse body bias RBB to the transmission driver 450d based on each ODT function of the transmission driver 450d being disabled.

In addition, it is understood that each of the ODT circuits 550a, 550b, 550c and 550d may be included in respective one of the transmission drivers 450a, 450b, 450c and 450d.

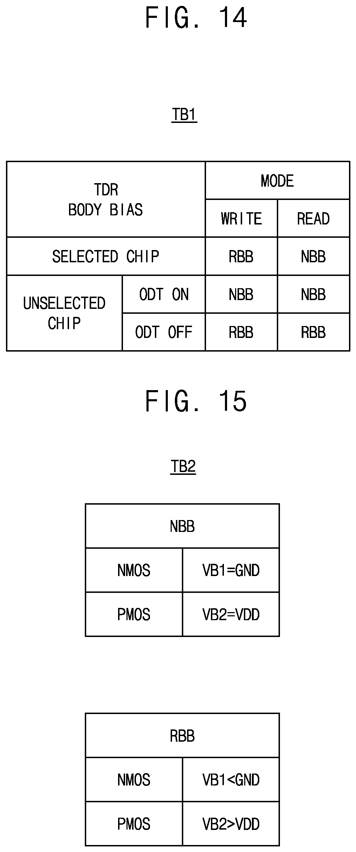

FIG. 14 is a table illustrating body bias applied to the transmission drivers in the memory chips in FIGS. 12 and 13.

Referring to FIG. 14, in a table TB1, a body bias applied to a transmission driver TDR of a target memory chip (selected chip) based on an operation mode and a body bias applied to a transmission driver TDR of a non-target memory chip (unselected chip) based on whether an ODT circuit is enabled.

As described with reference to FIGS. 12 and 13, a reverse body bias RBB is applied to the transmission driver 450a in the target memory chip 100a in the write mode and a normal body bias NBB is applied to the transmission driver 450a in the read mode. In addition, the normal body bias NBB is applied to the transmission drivers 450b and 450c in the memory chips 100b and 100c including the enabled ODT circuits 550b and 550c and the reverse body bias RBB is applied to the transmission driver 450d in the memory chip 100d including the disabled ODT circuit 550d.

FIG. 15 is a table illustrating body bias applied to transistors in the transmission driver according to example implementations.

In a table TB2, there are illustrated a normal body bias NBB and a reverse body bias RBB applied to transistors in the transmission driver 450a in FIG. 11.

Referring to FIG. 15, the bias voltage VB1 corresponding to the ground voltage GND may be applied to a body of at least one NMOS transistor NM in the transmission driver 450a as the normal body bias NBB and the bias voltage VB2 corresponding to the power supply voltage VDD may be applied to a body of at least one PMOS transistor PM in the transmission driver 450a as the normal body bias NBB. In addition, the bias voltage VB1 smaller than the ground voltage GND may be applied to a body of at least one NMOS transistor NM in the transmission driver 450a as the reverse body bias RBB and the bias voltage VB2 greater than the power supply voltage VDD may be applied to a body of at least one PMOS transistor PM in the transmission driver 450a as the reverse body bias RBB.

The at least one NMOS transistor NM may include a first NMOS transistor NM1 and a second NMOS transistor NM2.

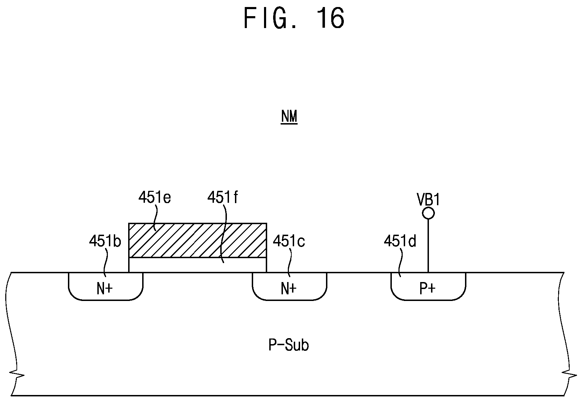

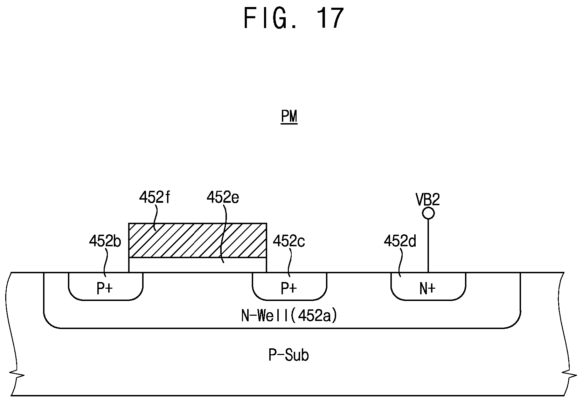

FIGS. 16 and 17 are cross-sectional views of a PMOS transistor and an NMOS transistor in the transmission driver in FIG. 11.

Referring to FIG. 16, N+ doping regions 451b and 451c acting as a drain and a source may be formed at a P-type substrate P-Sub to form the NMOS transistor NM. Also, a P+ doping region 451d for providing an NMOS body bias may be formed at the P-type substrate P-Sub. A gate insulation layer 451f and a gate electrode 451e may be sequentially stacked. The bias voltage VB1 is applied to the P+ doping region 451d.

When the bias voltage VB1 smaller than the ground voltage is applied to the P+ doping region 451d as the reverse body bias RBB, a depletion region under the gate insulation layer 451f may be increased and thus, junction capacitance of the NMOS transistor NM is reduced.

Referring to FIG. 17, an N-well 452a may be formed at a P-type substrate P-Sub to form the PMOS transistor PM. The N-well 452a may be formed by injecting N-type dopants into the P-type substrate P-Sub. Then, P+ doping regions 452b and 452c for a source and a drain of the PMOS transistor PM may be formed at the N-well 452a. An N+ doping region 452d for providing a PMOS body bias may be formed at the N-well 452a. A gate insulation layer 452e and a gate electrode 452f may be sequentially stacked. The gate insulation layer 452e may be formed of an oxide film, a nitride film or a film formed by stacking the oxide film and the nitride film. Also, the gate insulation layer 452e may be formed of a metal oxide film having high dielectric constant, a stack film formed by stacking the metal oxide film in a lamination structure, or a mixed film formed by mixing the metal oxide film and the stack film. The gate electrode 452f may be formed of a poly silicon film doped by an impurity ion or a metal layer. The bias voltage VB2 is applied to the N+ doping region 452d.

When the bias voltage VB2 greater than the power supply voltage is applied to the N+ doping region 452d as the reverse body bias RBB, a depletion region under the gate insulation layer 452e may be increased and thus, junction capacitance of the NMOS transistor PM is reduced.

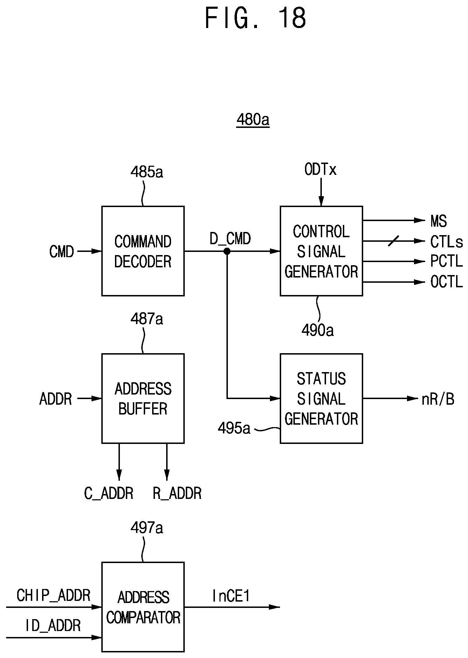

FIG. 18 is a block diagram illustrating an example of the control circuit in the memory chip of FIG. 5 according to example implementations.

Referring to FIG. 18, the control circuit 480a may include a command decoder 485a, an address buffer 487a, a control signal generator 490a, a status signal generator 495a and an address comparator 497a.

The command decoder 485a may decode the command CMD and provide a decoded command D_CMD to the control signal generator 490a and the status signal generator 495a.

The address buffer 487a may receive the address signal ADDR, provide the row address R_ADDR to the address decoder 300a and provide the column address C_ADDR to the data I/O circuit 420a.

The control signal generator 490a may receive the decoded command D_CMD and the ODT signal ODTx, may generate the control signals CTLs and the page buffer control signal PCTL, based on an operation directed by the decoded command D_CMD, may provide the control signals CTLs to the voltage generator 500a, and may provide the page buffer control signal PCTL to the page buffer circuits 410a, 410b, 410c and 410d. The control signal generator 490a may generate the mode signal MS based on the operation directed by the decoded command D_CMD, may generate the ODT control signal OCTL based on the ODT signal ODTx, may provide the mode signal MS and the ODT control signal OCTL to the adaptive body bias generator 460a and may provide the ODT control signal OCTL to the ODT circuit 550a.

The status signal generator 495a may receive the decoded command D_CMD, may monitor an operation directed by the decoded command D_CMD and may transition the status signal nR/B one of a ready state or a busy state based on whether the operation directed by the decoded command D_CMD is completed.

The address comparator 497a may compare the chip address CHIP_ADDR with the identifier address ID_ADDR of the memory chip 100a and may selectively activate the internal chip enable signal InCE1 based on a result of the comparison. The chip address CHIP _ADDR may designate a target memory chip. When the chip address CHIP_ADDR matches the identifier address ID_ADDR, the address comparator 497a may activate the internal chip enable signal InCE1 and when the chip address CHIP_ADDR is different from the identifier address ID_ADDR, the address comparator 497a may deactivate the internal chip enable signal InCE1.

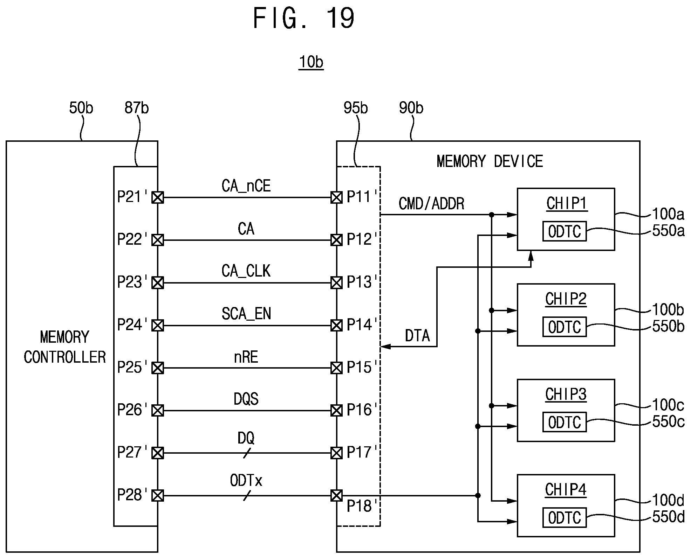

FIG. 19 is a block diagram illustrating a storage device according to example implementations.

Referring to FIG. 19, a storage device 10b may include a memory device 90b and a memory controller 50b. The memory device 90b and the memory controller 50b may communicate with each other based on a separate command address (SCA) scheme in which a command/address CA is transmitted separately with a data signal DQ. FIG. 19 illustrates an interface between the memory device 90b and the memory controller 50b in detail.

The memory device 90b may include first to eighth pins P11', P12', P13', P14', P15', P16', P17' and P18', an interface circuit 95b and a plurality of memory chips (CHIP 1, CHIP2, CHIP3 and CHIP4) 100a, 100b, 100c and 100d. The interface circuit 95b may be referred to as a first interface circuit. Each of the plurality of memory chips 100a, 100b, 100c and 100d may include a respective one of ODT circuits 550a, 550b, 550c and 550d.

The interface circuit 95b may receive a command/address chip enable signal CA_nCE from the memory controller 50b through the first pin P11', may receive a command/address CA from the memory controller 50b through the second pin P12', may receive a command/address clock signal CA_CLK from the memory controller 50b through the third pin P13' and may receive an SCA enable signal SCA_EN from the memory controller 50b through the fourth pin P14'.

The interface circuit 95b may receive a read enable signal nRE from the memory controller 50b through the fifth pin P15'. The interface circuit 95b may receive a data strobe signal DQS from the memory controller 50b through the sixth pin P16' or may transmit the data strobe signal DQS to the memory controller 50b. The interface circuit 95b may receive a data signal DQ from the memory controller 50b through the seventh pin P17' or may transmit the data signal DQ to the memory controller .

The interface circuit 95b may receive an ODT signal ODTx from the memory controller 50b through the eighth pin P18'. The ODT signal ODTx may indicate (e.g., designate) whether each of the ODT circuits 550a, 550b, 550c and 550d is enabled.

The memory controller 50b may include first to eighth pins P21', P22', P23', P24', P25', P26', P27' and P28' and an interface circuit 87b. The interface circuit 87b may be referred to as a second interface circuit. The first to eighth pins P21' to P28' may correspond to the first to eighth pins P11' to P18' of the memory device 90b, respectively.

The interface circuit 87b may transmit the command/address chip enable signal CA_nCE to the memory device 90b through the first pin P21', may transmit the command/address CA to the memory device 90b through the second pin P22', may transmit the command/address clock signal CA_CLK to the memory device 90b through the third pin P23' and may transmit the SCA enable signal SCA_EN to the memory device 90b through the fourth pin P24'.

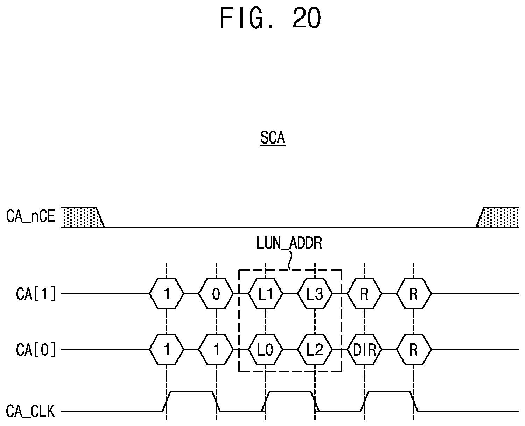

FIG. 20 is a timing diagram illustrating a chip selection operation of the memory device in FIG. 19 according to example implementations.

Referring to FIGS. 19 and 20, a chip selection operation may be an operation to select a target memory chip among a plurality of memory chips based on the command/address chip enable signal CA_nCE and the command/address CA and may be performed through the SCA scheme. During an interval in which the command/address chip enable signal CA_nCE is in an enable state (e.g., a low level), the memory device 90b may receive the command/address CA[1:0] through the second pins P12'. The memory controller 50b may transmit the command/address CA[1:0] to the memory device 90b in synchronization with a rising edge and a falling edge of the command/address clock signal CA_CLK. For example, during three cycles of the command/address clock signal CA_CLK, the command/address CA[1:0] may be transmitted as a select chip enable SCE packet.

For example, the command/address CA[1:0] may include a logical unit number (LUN) address LUN_ADDR indicating an active LUN. For example, the LUN address LUN_ADDR may be transmitted as a portion of the SCE packet. Here, LUN is a minimum unit capable of executing a command independently and the LUN may correspond to a memory chop. The memory device 90b may determine a target memory chip and non-target memory chips among the plurality memory chips 100a, 100b, 100c and 100d based on the LUN address LUN_ADDR. Each of the plurality memory chips 100a, 100b, 100c and 100d may determine whether each of the plurality memory chips 100a, 100b, 100c and 100d is a target memory chip or a non-target memory chip based on the LUN address LUN_ADDR.

A control circuit (for example, the control circuit 480a in FIG. 18) may compare the LUN address LUN_ADDR with an identifier address of each of the memory chips 100a, 100b, 100c and 100d and may determine whether each of the plurality memory chips 100a, 100b, 100c and 100d is a target memory chip or a non-target memory chip based on a result of the comparison. In FIG. 20, 'R' denotes a reserved bit and 'DIR' denotes a data direction.

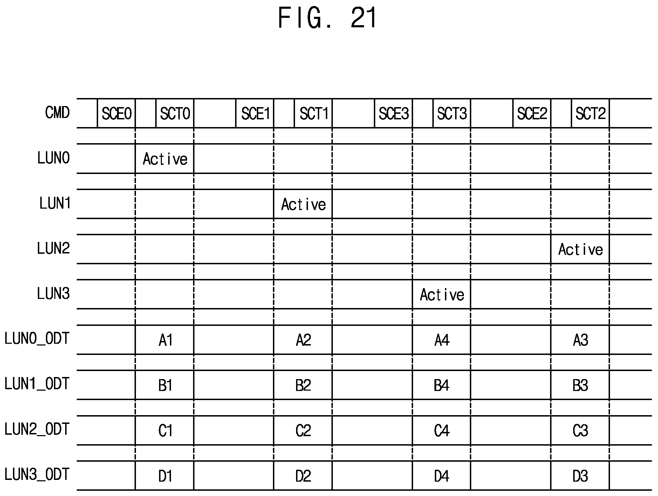

FIG. 21 is a timing diagram illustrating an example of ODT control operation of the memory device in FIG. 19 according to example implementations.

Referring to FIG. 21, the memory device 90b may sequentially receive a select chip enable signal SCEO that activates LUN0 and a select chip termination signal SCT0 that terminates LUN0 through the second pins P12' through the memory controller 50b. The select chip enable signal SCE0 may be transmitted in a form of a packet. The memory chip 100a corresponding to LUN0 is selected in response to the select chip enable signal SCE0 and the memory chips 100b, 100c and 100d respectively corresponding to LUN1, LUN2 and LUN3 may be unselected. ODT resistance values LUN0_ODT, LUN1_ODT, LUN2_ODT and LUN3_ODT of the memory chips 100a, 100b, 100c and 100d may be determined as A1, B1, C1 and D1, respectively.

The memory device 90b may sequentially receive a select chip enable signal SCE1 that activates LUN1 and a select chip termination signal SCT1 that terminates LUN1 through the second pins P12' through the memory controller 50b. The memory chip 100b corresponding to LUN1 is selected in response to the select chip enable signal SCE1 and the memory chips 100a, 100c and 100d respectively corresponding to LUN0, LUN2 and LUN3 may be unselected. ODT resistance values LUN0_ODT, LUN1_ODT, LUN2_ODT and LUN3_ODT of the memory chips 100a, 100b, 100c and 100d may be determined as A2, B2, C2 and D2, respectively.

The memory device 90b may sequentially receive a select chip enable signal SCE3 that activates LUN3 and a select chip termination signal SCT3 that terminates LUN3 through the second pins P12' through the memory controller 50b. The memory chip 100d corresponding to LUN3 is selected in response to the select chip enable signal SCE3 and the memory chips 100a, 100b and 100c respectively corresponding to LUN0, LUN1 and LUN2 may be unselected. ODT resistance values LUN0_ODT, LUN1_ODT, LUN2_ODT and LUN3_ODT of the memory chips 100a, 100b, 100c and 100d may be determined as A4, B4, C4 and D4, respectively.

The memory device 90b may sequentially receive a select chip enable signal SCE2 that activates LUN2 and a select chip termination signal SCT2 that terminates LUN2 through the second pins pP12' through the memory controller 50b. The memory chip 100c corresponding to LUN2 is selected in response to the select chip enable signal SCE2 and the memory chips 100a, 100b and 100d respectively corresponding to LUN0, LUN1 and LUN3 may be unselected. ODT resistance values LUN0_ODT, LUN1_ODT, LUN2_ODT and LUN3_ODT of the memory chips 100a, 100b, 100c and 100d may be determined as A3, B3, C3 and D3, respectively.

Each of the memory chips 100a, 100b , 100c and 100d in the memory device 90b in FIG. 19 may include an adaptive body bias generator, a transmission driver and an ODT circuit and may perform operations described with reference to FIGS. 12 and 13.

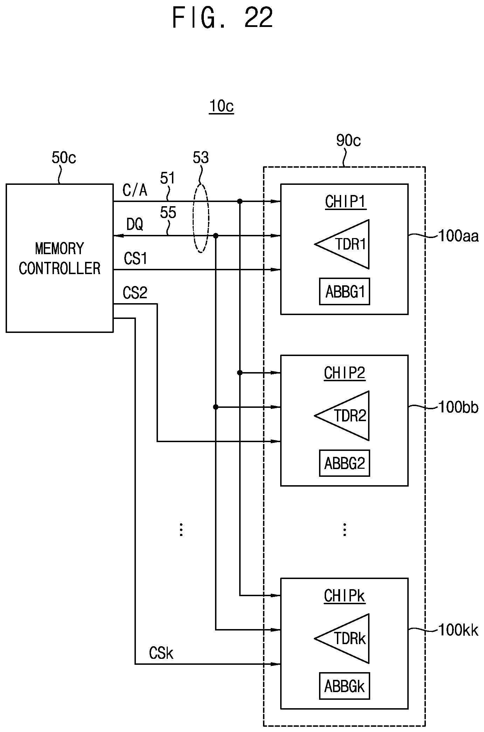

FIG. 22 is a block diagram illustrating a storage device according to example implementations.

Referring to FIG. 22, a storage device 10c may include a memory controller 50c and a memory device 90c. The memory device 90c may include a plurality of memory chips (CHIP 1, CHIP2, ..., CHIPk) 100aa, 100bb, ..., 100kk and each of the plurality of memory chips 100aa, 100bb, ..., 100kk may be a volatile memory device (such as DRAM) including volatile memory cells coupled to word-lines and bit-lines.

The plurality of memory chips 100aa, 100bb, ..., 100kk may share a data bus 55 to transfer data DQ and a command/address (CA) bus 51 to transfer a command and an address CA and may receive respective ones of chip selection signals CS1, CS2, ..., CSk. The CA bus 51 and the data bus 55 may constitute one channel 53.

A memory chip of the plurality of memory chips 100aa, 100bb, ..., 100kk, which is selected by one of the chip selection signals CS1, CS2, ..., CSk, having a first logic level, is referred to as a target memory chip, and at least one memory chip of the plurality of memory chips 100aa, 100bb, ..., 100kk, which is unselected by one of the chip selection signals CS1, CS2, ..., CSk, having a second logic level, is referred to as a non-target memory chip.

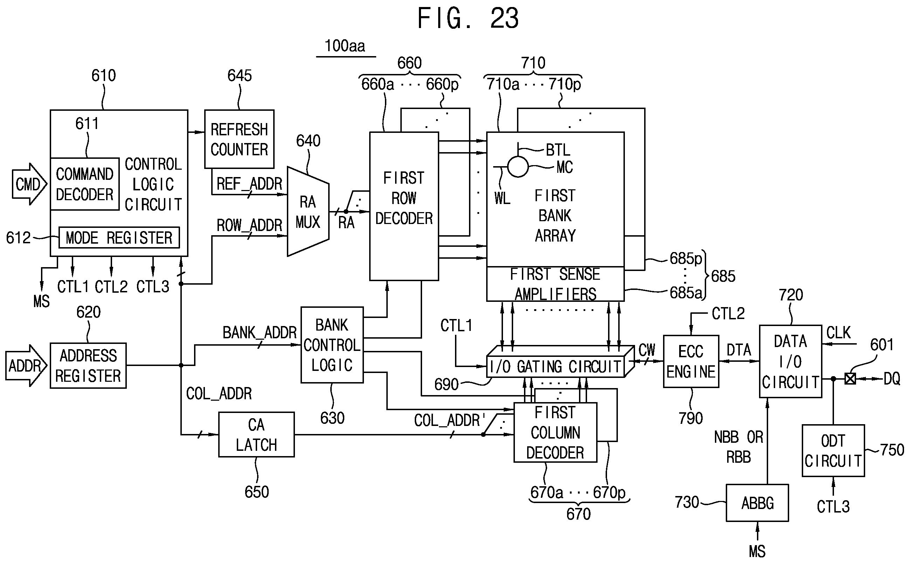

FIG. 23 is a block diagram illustrating an example of one of the plurality of memory chips in the memory device in FIG. 22 according to example implementations.

In FIG. 23, a configuration of the memory chip 100aa is illustrated and each configuration of the memory chips 100bb, ..., 100kk may be substantially the same as the configuration of the memory chip 100aa.

Referring to FIG. 23, the memory chip 100aa may include a control logic circuit 610, an address register 620, a bank control logic 630, a row address multiplexer 640, a column address latch 650, a row decoder 660, a column decoder 670, a memory cell array 710, a sense amplifier unit 685, an I/O gating circuit 690, a refresh counter 645, a data I/O circuit 720, an error correction code (ECC) engine 790, an adaptive body bias generator 730 and an ODT circuit 750.

The memory cell array 710 may include first through sixteenth bank arrays 710a~710p. The row decoder 660 may include first through sixteenth row decoders 660a~660p respectively coupled to the first through sixteenth bank arrays 710a~710p. The column decoder 670 may include first through sixteenth column decoders 670a~670p respectively coupled to the first through sixteenth bank arrays 710a~710p. The sense amplifier unit 685 may include first through sixteenth sense amplifiers 685a~685p respectively coupled to the first through sixteenth bank arrays 710a~710p. The first through sixteenth bank arrays 710a~710p, the first through sixteenth row decoders 660a~660p, the first through sixteenth column decoders 670a~670p, and first through sixteenth sense amplifiers 685a~685p may form first through sixteenth banks.

Each of the first through eighth bank arrays 710a~710h may include a plurality of memory cells MC, formed at intersections of a plurality of word-lines WL and a plurality of bit-line BTL.

The address register 620 may receive the address ADDR including a bank address BANK _ADDR, a row address ROW_ADDR, and a column address COL_ADDR from the memory controller 50. The address register 620 may provide the received bank address BANK_ADDR to the bank control logic 630, provide the received row address ROW_ADDR to the row address multiplexer 640, and provide the received column address COL_ADDR to the column address latch 650.

The bank control logic 630 may generate bank control signals in response to the bank address BANK_ADDR. One of the first through sixteenth row decoders 660a~660p corresponding to the bank address BANK_ADDR may be activated in response to the bank control signals, and one of the first through sixteenth column decoders 670a~670p corresponding to the bank address BANK_ADDR may be activated in response to the bank control signals.

The row address multiplexer 640 may receive the row address ROW_ADDR from the address register 620, and may receive a refresh row address REF_ADDR from the refresh counter 645. The row address multiplexer 640 may selectively output one of the row address ROW_ADDR and the refresh row address REF_ADDR as a row address RA. The row address RA that is output from the row address multiplexer 640 may be applied to the first through sixteenth row decoders 660a~660p.

The refresh counter 645 may sequentially increase or decrease the refresh row address REF_ADDR under control of the control logic circuit 610.

The activated one of the first through sixteenth row decoders 660a~660p may decode the row address RA that is output from the row address multiplexer 640, and may activate a word-line corresponding to the row address RA. For example, the activated bank row decoder may apply a word-line driving voltage to the word-line corresponding to the row address RA.

The column address latch 650 may receive the column address COL_ADDR from the address register 620, and may temporarily store the received column address COL _ADDR. In example implementations, in a burst mode, the column address latch 650 may generate column addresses COL_ADDR' that increment from the received column address COL _ADDR. The column address latch 650 may apply the temporarily stored or generated column address COL_ADDR' to the first through sixteenth column decoders 670a~670p.

The activated one of the first through sixteenth column decoders 670a~670p may decode the column address COL_ADDR' that is output from the column address latch 650, and may control the I/O gating circuit 690 to output data corresponding to the column address COL_ADDR.

The I/O gating circuit 690 may include circuitry for gating input/output data. The I/O gating circuit 690 may further include read data latches for storing data that is output from the first through sixteenth bank arrays 710a~710p, and write drivers for writing data to the first through sixteenth bank arrays 710a~710p.

A codeword CW that is read from one bank array of the first through sixteenth bank arrays 710a~710p may be sensed by a sense amplifier coupled to the one bank array from which the data is to be read, and may be stored in the read data latches. The codeword CW stored in the read data latches may be provided to the ECC engine 790. The ECC engine 690 may perform an ECC decoding on the codeword CW to provide the data DTA to the data I/O circuit 620. The data I/O circuit 620 may convert the data DTA to the data signal DQ and may transmit the data signal DQ to the memory controller 50c.

The data signal DQ to be written in one bank array of the first through sixteenth bank arrays 710a~710p may be provided to the data I/O circuit 620 from the memory controller 50c. The data I/O circuit 720 may convert the data signal DQ to the data DTA and provide the data DTA to the ECC engine 790. The ECC engine 790 may perform an ECC encoding on the data DTA to generate parity bits and the ECC engine 790 may provide the data DTA and the parity bits to the I/O gating circuit 690. The I/O gating circuit 690 may write the data DTA and the parity bits in a sub-page in one bank array through the write drivers.

The data I/O circuit 720 may drive bits of the data DTA to generate the data signal DQ and provide the data signal DQ to the memory controller 50c through a data I/O pin 601.

The ECC engine 790 may perform an ECC encoding and ECC decoding on the data DTA based on a second control signal CTL2 from the control logic circuit 610.

When the memory chip 100aa is selected as a target memory chip, the adaptive body bias generator 730 may apply a different body bias to a transmission driver in the data I/O circuit 720 in a write mode and a read mode based on a mode signal MS. For example, in the write mode in which the memory chip 100aa receives the data signal DQ from the memory controller 50c, the adaptive body bias generator 730 may apply a reverse body bias RBB to the transmission driver in the data I/O circuit 720 and in the read mode in which the memory chip 100aa transmits the data signal DQ to the memory controller 50c, the adaptive body bias generator 730 may apply a normal body bias NBB to the transmission driver in the data I/O circuit 720.

The ODT circuit 750 may be coupled to the data I/O pin 601, may be selectively enabled based on a third control signal CTL3 and may provide a termination resistance to a data transmission line coupled to the data I/O pin 601 when the data I/O circuit 720 transmits the data signal DQ or receives the data signal DQ.

When the memory chip 100aa is not selected as a target memory chip, the adaptive body bias generator 730 may apply a different body bias to the transmission driver in the data I/O circuit 720 based on whether the ODT circuit 750 is enabled.

When the ODT circuit 750 is enabled, the adaptive body bias generator 730 may apply the normal body bias NBB to the transmission driver, and when the ODT circuit 750 is disabled, the adaptive body bias generator 730 may apply the reverse body bias RBB to the transmission driver.

The control logic circuit 610 may control operations of the memory chip 100aa. For example, the control logic circuit 610 may generate control signals for the memory chip 100aa in order to perform a write operation or a read operation. The control logic circuit 610 may include a command decoder 611 that decodes the command CMD received from the memory controller 50c, and may include a mode register 612 that sets an operation mode of the memory chip 100aa.

The command decoder 612 may generate the control signals corresponding to the command CMD by decoding a write enable signal, a row address strobe signal, a column address strobe signal, a chip select signal, etc. The control logic circuit 610 may generate a first control signal CTL1 to control the I/O gating circuit 690, may generate the second control signal CTL2 to control the ECC engine 790, may generate the third control signal CTL3 to control the ODT circuit 750 and may generate the mode signal MS to control the adaptive body bias generator 730.

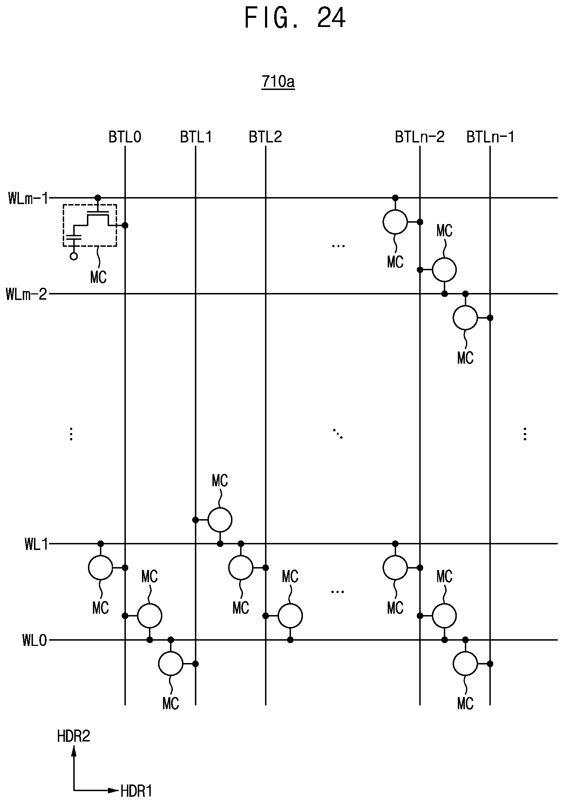

FIG. 24 illustrates an example of a first bank array in the memory chip of FIG. 23 according to example implementations.

Referring to FIG. 24, the first bank array 710a may include a plurality of word-lines WL0~WLm-1 (m is a natural number greater than two), a plurality of bit-lines BTL0~BTLn-1 (n is a natural number greater than two), and a plurality of memory cells MCs disposed at intersections between the word-lines WL0~WLm-1 and the bit-lines BTL0~BTLn-1. Each of the memory cells MCs may include a cell transistor coupled to each of the word-lines WL0~WLm-1 and each of the bit-lines BTL0~BTLn-1 and a cell capacitor coupled to the cell transistor. Each of the memory cells MCs may have a DRAM cell structure. Each of the word-lines WL0~WLm-1 extends in a first horizontal direction HDR1 and each of the bit-lines BTL1~BTLn-1 extends in a second horizontal direction HDR2 crossing the first horizontal direction HDR1.

The word-lines WL0~WLm-1 coupled to the plurality of memory cells MCs may be referred to as rows of the first bank array 710a and the bit-lines BTL0~BTLn-1 coupled to the plurality of memory cells MCs may be referred to as columns of the first bank array 710a.

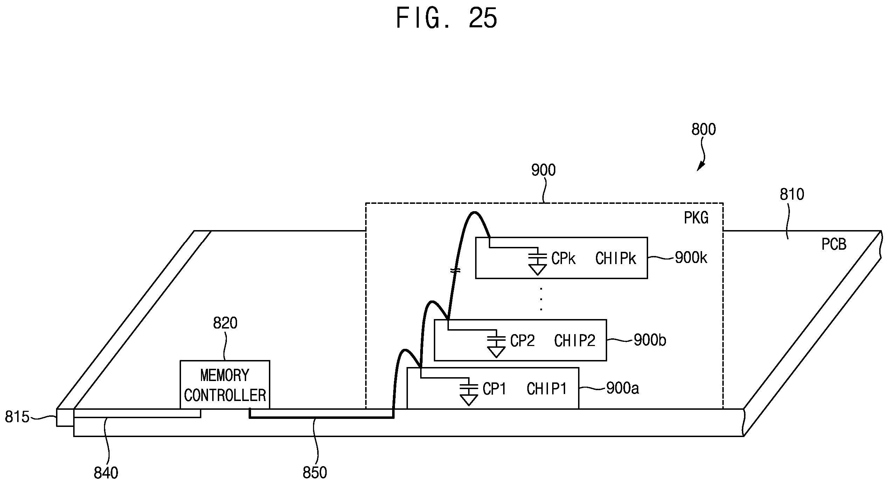

FIG. 25 is a block diagram illustrating an example of the storage device in FIG. 1 according to example implementations.

Referring to FIG. 25, a storage device 800 may include a memory controller 820 and a package 900 including a plurality of memory chips 900a~900k provided on a printed circuit board (PCB) 810.

The memory controller 820 and the plurality of memory chips 900a~900k may be electrically coupled to each other through a transmission line 850. The memory controller 820 may transmit a command signal and an address signal to the plurality of memory chips 900a~900k and may exchange data with the plurality of memory chips 900a~900k through the transmission line 850.

The memory controller 820 may be connected to a connector 815 through a transmission line 840 and the connector 815 may be connected to an external host.

The storage device 800 may include flash memory based data storage media such as a memory card, a smart card, a universal serial bus (USB) memory, a solid state drive (SSD).

The package 900 may include the plurality of memory chips 900a~900k. When the plurality of memory chips 900a~900k are contained in the package 900 in the form of multi-stack chip, the stacked of memory chips 900a~900k are connected to the memory controller 820 through the same channel. The plurality of memory chips 900a~900k may be sequentially stacked on the PCB 810 in a direction vertical to a surface of the PCB 810. A specific memory chip (for example, the memory chip 900a) from which data is to be read or to which data is to be written can be selected when a command associated with a read or write operation is received from the host.

However, unselected memory chips 900b~900k are connected to the memory controller 820 through the transmission line 850. Therefore, a capacitance of the channel may include parasitic capacitance of unselected memory chips 900b~900k that are not associated with a read or write operation. That is, a capacitance CP1 of the memory chip 900a and capacitances CP2~CPk of the memory chips 900b~900k may influence the capacitance of the channel.

In terms of signal integrity, the parasitic capacitance influences data transmission through the channel and when the parasitic capacitance increases, power consumption may increase.

For reducing power consumption, each of the memory chips 900a~900k may include an adaptive body bias generator mentioned above. An adaptive body bias generator in a selected chip may apply a body bias to a corresponding transmission driver, and the body bias being applied may vary (be different) based on an operation mode. An adaptive body bias generator in an unselected chip may apply a body bias to a corresponding transmission driver, and the applied body bias may vary (be different) based on whether an ODT function is enabled. Therefore, the adaptive body bias generator may apply a reverse body bias to a corresponding transmission driver in the write mode or when the ODT function is disabled and may reduce power consumption by reducing parasitic capacitance.

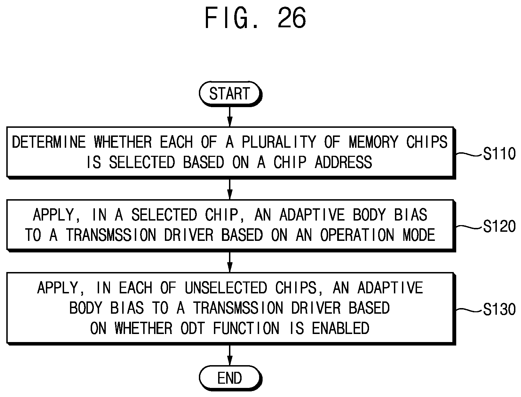

FIG. 26 is a flow chart illustrating a method of operating a storage device according to example implementations.

Referring to FIGS. 1 through 21 and 26, there is provided a method of operating a storage device 10a that includes a memory device 90a and a memory controller 50 to control the memory device 90a by communicating with the memory device 90a through a channel, where the memory device 90a includes a plurality of memory chips 100a, 100b, 100c and 100d sharing the channel.

According to the method, it is determined whether each of a plurality of memory chips 100a, 100b, 100c and 100d is selected as a target memory chip based on a chip address CHIP _ADDR from the memory controller 50 (operation S110).

A first adaptive body bias generator 460a, in a first memory chip 100a selected as the target memory chip among the plurality of memory chips 100a, 100b, 100c and 100d, applies a first body bias to a first transmission driver 450a based on an operation mode being a write mode or a read mode (operation S120).

A second adaptive body bias generator 460b, in each of non-target memory chips 100b, 100c and 100d, except for the first memory chip 100a selected as the target memory chip among the plurality of memory chips 100a, 100b, 100c and 100d, applies a second body bias to a second transmission driver based on whether a corresponding on-die termination function is enabled (operation S130).

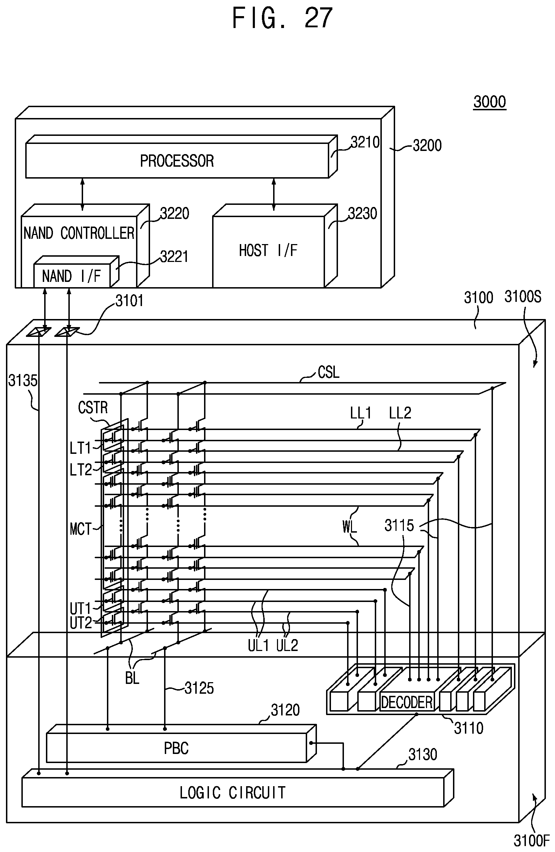

FIG. 27 is a block diagram illustrating an electronic system including a semiconductor device according to some example implementations.

Referring to FIG. 27, an electronic system 3000 may include a semiconductor device 3100 and a controller 3200 electrically connected to the semiconductor device 3100. The electronic system 3000 may be a storage device including one or a plurality of semiconductor devices 3100 or an electronic device including a storage device. For example, the electronic system 3000 may be a solid state drive (SSD) device, a universal serial bus (USB), a computing system, a medical device, or a communication device that may include one or a plurality of semiconductor devices 3100.

The semiconductor device 3100 may be or may include a memory device, for example, a memory device that is illustrated with reference to FIGS. 1 to 21. The semiconductor device 3100 may include a first structure 3100F and a second structure 3100S on the first structure 3100F. The first structure 3100F may be a peripheral circuit structure including a decoder circuit 3110, a page buffer circuit (PBC) 3120, and a logic circuit 3130. The second structure 3100S may be a memory cell structure including a bit-line BL, a common source line CSL, word-lines WL, first and second upper gate lines UL1 and UL2, first and second lower gate lines LL1 and LL2, and memory cell strings CSTR between the bit line BL and the common source line CSL.

In the second structure 3100S, each of the memory cell strings CSTR may include lower transistors LT1 and LT2 adjacent to the common source line CSL, upper transistors UT1 and UT2 adjacent to the bit-line BL, and a plurality of memory cell transistors MCT between the lower transistors LT1 and LT2 and the upper transistors UT1 and UT2. The number of the lower transistors LT1 and LT2 and the number of the upper transistors UT1 and UT2 may be varied in accordance with example implementations.

In some example implementations, the upper transistors UT1 and UT2 may include string selection transistors, and the lower transistors LT1 and LT2 may include ground selection transistors. The lower gate lines LL1 and LL2 may be gate electrodes of the lower transistors LT1 and LT2, respectively. The word lines WL may be gate electrodes of the memory cell transistors MCT, respectively, and the upper gate lines UL1 and UL2 may be gate electrodes of the upper transistors UT1 and UT2, respectively.

In some example implementations, the lower transistors LT1 and LT2 may include a lower erase control transistor LT1 and a ground selection transistor LT2 that may be connected with each other in serial. The upper transistors UT1 and UT2 may include a string selection transistor UT1 and an upper erase control transistor UT2. At least one of the lower erase control transistor LT1 and the upper erase control transistor UT2 may be used in an erase operation for erasing data stored in the memory cell transistors MCT through gate induced drain leakage (GIDL) phenomenon.

The common source line CSL, the first and second lower gate lines LL1 and LL2, the word lines WL, and the first and second upper gate lines UL1 and UL2 may be electrically connected to the decoder circuit 3110 through first connection wirings 3115 extending to the second structure 3110S from the first structure 3100F. The bit-lines BL may be electrically connected to the page buffer circuit 3120 through second connection wirings 3125 extending to the second structure 3100S from the first structure 3100F.

In the first structure 3100F, the decoder circuit 3110 and the page buffer circuit 3120 may perform a control operation for at least one selected memory cell transistor among the plurality of memory cell transistors MCT. The decoder circuit 3110 and the page buffer circuit 3120 may be controlled by the logic circuit 3130. The semiconductor device 3100 may communicate with the controller 3200 through an input/output pad 3101 electrically connected to the logic circuit 3130. The input/output pad 3101 may be electrically connected to the logic circuit 3130 through an input/output connection wiring 3135 extending to the second structure 3100S from the first structure 3100F.

The controller 3200 may include a processor 3210, a NAND controller 3220, and a host interface (I/F) 3230. The electronic system 3000 may include a plurality of semiconductor devices 3100, and in this case, the controller 3200 may control the plurality of semiconductor devices 3100.

The processor 3210 may control operations of the electronic system 3000 including the controller 3200. The processor 3210 may be operated by firmware, and may control the NAND controller 3220 to access the semiconductor device 3100. The NAND controller 3220 may include a NAND interface 3221 for communicating with the semiconductor device 3100. Through the NAND interface 3221, control command for controlling the semiconductor device 3100, data to be written in the memory cell transistors MCT of the semiconductor device 3100, data to be read from the memory cell transistors MCT of the semiconductor device 3100, etc., may be transferred. The host interface 3230 may provide communication between the electronic system 3000 and an outside host. When control command is received from the outside host through the host interface 3230, the processor 3210 may control the semiconductor device 3100 in response to the control command.

A storage device according to example implementations may be packaged using various package types or package configurations.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementations. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The foregoing is illustrative of example implementations and is not to be construed as limiting thereof. Although a few example implementations have been described, those skilled in the art will readily appreciate that many modifications are possible in the example implementations without materially departing from the novel teachings and advantages of the present disclosure. Accordingly, all such modifications are intended to be included within the scope of the present disclosure as defined in the claims.

## Claims

1. A storage device comprising:
a memory device; and
a memory controller configured to control the memory device through a channel,
wherein the memory device includes a plurality of memory chips sharing the channel, the memory device being configured to select a target memory chip among the plurality of memory chips,
wherein the target memory chip includes a first adaptive body bias generator and a first transmission driver,
wherein the first adaptive body bias generator is configured to apply a first body bias to the first transmission driver based on an operation mode, the operation mode including a write mode or a read mode, and
wherein the target memory chip is configured to receive a write data from the memory controller in the write mode and transmit a read data to the memory controller in the read mode.

2. The storage device of claim 1, wherein the first adaptive body bias generator is configured to:
apply a reverse body bias to the first transmission driver in the write mode; and
apply a normal body bias to the first transmission driver in the read mode.

3. The storage device of claim 1, wherein the first transmission driver includes a first n-type metal-oxide semiconductor (NMOS) transistor and a first p-type metal-oxide semiconductor (PMOS) transistor,
wherein the first NMOS transistor and the first PMOS transistor are connected to a data transmission line that is included in the channel, and
wherein the data transmission line is configured to transfer the read data and receive the write data.

4. The storage device of claim 3, wherein the first adaptive body bias generator is configured to apply, in the write mode, a reverse body bias to the first transmission driver by:
applying a first bias voltage smaller than a ground voltage to a body of the first NMOS transistor; and
applying a second bias voltage greater than a power supply voltage to a body of the first PMOS transistor.

5. The storage device of claim 3, wherein the first adaptive body bias generator is configured to apply, in the read mode, a normal body bias to the first transmission driver by:
applying a first bias voltage corresponding to a ground voltage to a body of the first NMOS transistor; and
applying a second bias voltage of a power supply voltage to a body of the first PMOS transistor.

6. The storage device of claim 3,
wherein each of one or more non-target memory chips unselected by the memory controller, among the plurality of memory chips, includes an on-die termination (ODT) circuit connected to the data transmission line,
wherein each of the one or more non-target memory chips includes a corresponding adaptive body bias generator and a corresponding transmission driver, and
wherein the corresponding adaptive body bias generator is configured to apply a second body bias to the corresponding transmission driver based on a corresponding ODT circuit being enabled.

7. The storage device of claim 6,
wherein the one or more non-target memory chips include a first non-target memory chip including a first ODT circuit that is enabled and a second non-target memory chip including a second ODT circuit that is disabled,
wherein the first non-target memory chip includes a second adaptive body bias generator and a second transmission driver,
wherein the second non-target memory chip includes a third adaptive body bias generator and a third transmission driver,
wherein the second adaptive body bias generator is configured to apply a normal body bias to the second transmission driver, and
wherein the third adaptive body bias generator is configured to apply a reverse body bias to the third transmission driver.

8. The storage device of claim 7, wherein the third transmission driver includes a second NMOS transistor and a second PMOS transistor,
wherein the second NMOS transistor and the second PMOS transistor are connected to the data transmission line, and
wherein the third adaptive body bias generator is configured to apply the reverse body bias to the third transmission driver by:
applying a first bias voltage smaller than a ground voltage to a body of the second NMOS transistor; and
applying a second bias voltage greater than a power voltage to a body of the second PMOS transistor.

9. The storage device of claim 7, wherein the second transmission driver includes a second NMOS transistor and a second PMOS transistor,
wherein the second NMOS transistor and the second PMOS transistor are connected to the data transmission line, and
wherein the second adaptive body bias generator is configured to apply the normal body bias to the second transmission driver by:
applying a first bias voltage corresponding to a ground voltage to a body of the second NMOS transistor; and
applying a second bias voltage of a power supply voltage to a body of the second PMOS transistor.

10. The storage device of claim 6,
wherein each of the one or more non-target memory chips determines that a corresponding ODT circuit is enabled based on an ODT signal received from the memory controller, and
wherein the corresponding ODT circuit is included in a corresponding transmission driver of each of the one or more non-target memory chips.

11. The storage device of claim 1, wherein each of the plurality of memory chips includes:
a memory cell array including a plurality of nonvolatile memory cells coupled to a plurality of word-lines and a plurality of bit-lines, the memory cell array configured to store the write data and provide the read data;
an on-die termination (ODT) circuit connected to a data transmission line configured to transfer the read data and receive the write data, the data transmission line being included in the channel; and
a control circuit configured to control a corresponding body bias generator based on a command and an address received from the memory controller and control the ODT circuit based on an ODT signal received from the memory controller, and
wherein the plurality of memory chips are sequentially stacked on a printed circuit board in a direction vertical to a surface of the printed circuit board,
wherein the control circuit includes:
an address comparator configured to generate an internal chip enable signal designating the target memory chip by comparing a chip address included in the address with an identifier address identifying each of the plurality of memory chips; and
a control signal generator configured to generate an ODT control signal that selectively enables the ODT circuit based on the ODT signal.

12. The storage device of claim 11, wherein the address comparator is configured to:
activate the internal chip enable signal based on the chip address matching the identifier address; and
deactivate the internal chip enable signal based on the chip address being different from the identifier address.

13. The storage device of claim 11, wherein the plurality of memory chips are configured to operate in a chip enable reduction mode in which the plurality of memory chips commonly receive a chip enable signal and a chip address, and
wherein the control circuit is configured to:
selectively activate an internal chip enable signal designating the target memory chip based on a command/address chip enable signal and a command/address received from the memory controller; and
generate an ODT control signal that selectively enables the ODT circuit based on the ODT signal, and
wherein the command/address includes a logical unit number (LUN) address indicating an active LUN.

14. A storage device comprising:
a memory device; and
a memory controller configured to control the memory device through a channel and to select a target memory chip among a plurality of memory chips,
wherein the memory device includes the plurality of memory chips sharing a data bus that transfers data and receiving respective chip selection signals from the memory controller,
wherein each of the plurality of memory chips includes a memory cell array, a transmission driver and an adaptive body bias generator, the memory cell array including a plurality of volatile memory cells coupled to a plurality of word-lines and a plurality of bit-lines, the memory cell array configured to store the data,
wherein the target memory chip includes a first adaptive body bias generator and a first transmission driver, and
wherein the first adaptive body bias generator is configured to apply a first body bias to the first transmission driver based on an operation mode, the operation mode including a write mode or a read mode, and
wherein the target memory chip is configured to receive a write data from the memory controller in the write mode and transmit a read data to the memory controller in the read mode.

15. The storage device of claim 14, wherein the first adaptive body bias generator is configured to:
apply a reverse body bias to the first transmission driver in the write mode; and
apply a normal body bias to the first transmission driver in the read mode,
wherein the first transmission driver includes a first n-type metal-oxide semiconductor (NMOS) transistor and a first p-type metal-oxide semiconductor (PMOS) transistor that are connected to the data bus,
wherein the first adaptive body bias generator is configured to apply, in the write mode, the reverse body bias to the first transmission driver by:
applying a first bias voltage smaller than a ground voltage to a body of the first NMOS transistor; and
applying a second bias voltage greater than a power voltage to a body of the first PMOS transistor, and
wherein the first adaptive body bias generator is configured to apply, in the read mode, the normal body bias to the first transmission driver by:
applying the first bias voltage corresponding to the ground voltage to the body of the first NMOS transistor; and
applying the second bias voltage of a power supply voltage to the body of the first PMOS transistor.
